# DEMANDE DE BREVET EUROPEEN

(11) **EP 4 361 648 A1**
(43) Date de publication de la demande: **01.05.2024**
(21) Numéro de dépôt: 23203527.9
(22) Date de dépôt: 13.10.2023
(51) Int. Cl.: G01R 25/00, H03B 27/00, H04L 27/34

(54) **DETECTION DE SIGNAUX I ET Q**

(30) Priorité: 24.10.2022 FR 2211018
(71) Demandeur: STMicroelectronics France, 92120 Montrouge (FR)
(72) Inventeur: GIRY-CASSAN, Florence, 38700 CORENC (FR)
(74) Mandataire: Cabinet Beaumont

(57) **Abrégé**

La présente description concerne un dispositif comprenant un circuit recevant deux signaux sinusoïdaux (sig1, sig3) en quadrature et fournissant :
- un premier signal carré (sig11) correspondant à un premier des deux signaux, et
- un deuxième signal carré (sig31) correspondant à un deuxième des deux signaux ; et
une porte logique recevant les deux signaux carrés (sig11, sig31) et fournissant, quand les premier et deuxième signaux carrés sont simultanément à un premier niveau, des troisième et quatrième signaux carrés (O1, O2) respectivement à un premier niveau et à un deuxième niveau si le premier signal sinusoïdal est en avance de phase, et respectivement au deuxième niveau et au premier niveau si le deuxième signal sinusoïdal est en avance de phase.

## Description

### Domaine technique

La présente description concerne de façon générale les circuits électroniques, et, plus particulièrement les circuits électroniques comprenant des circuits de fourniture de deux signaux en quadrature.

### Technique antérieure

On connaît des circuits électroniques pour des technologies ou des applications Ultra Large Bande (UWB, de l'anglais Ultra Wide Band) qui permettent des mesures précises de la distance entre un émetteur et un récepteur sans fil. De tels circuits sont appelés circuits Ultra Large Bande.

En particulier, un circuit récepteur UWB comprend un mélangeur ("mixer" en anglais) configuré pour translater en fréquence un signal reçu ayant une fréquence comprise entre, par exemple, 6 et 10 GHz en deux signaux en bande de base. Un premier des deux signaux en bande de base est en avance de phase par rapport au deuxième, le deuxième signal en bande de base étant donc en retard de phase par rapport au premier. L'obtention des deux signaux en bande de base nécessite deux signaux, couramment appelés signaux d'oscillateur local, respectivement en phase et en quadrature de phase. Pour permettre un traitement numérique des signaux en bande de base, par exemple pour déterminer avec précision une mesure de distance entre le récepteur UWB et un émetteur UWB, il y a un besoin de savoir lequel des deux signaux d'oscillateur local est le signal I en phase et lequel est le signal Q en quadrature de phase, de manière à savoir lequel des deux signaux en bande de base est le signal en avance de phase et lequel est le signal en retard de phase.

### Résumé de l'invention

Il existe un besoin de pallier tout ou partie des inconvénients des circuits Ultra Large Bande connus.

Par exemple, il existe un besoin d'un circuit Ultra Large Bande permettant d'identifier parmi deux signaux d'oscillateur local en quadrature lequel est le signal I en phase et lequel est le signal Q en quadrature.

Un mode de réalisation pallie tout ou partie des inconvénients des circuits Ultra Large Bande connus.

Par exemple, un mode de réalisation prévoit un circuit Ultra Large Bande apte à identifier parmi deux signaux d'oscillateur local en quadrature lequel est le signal I en phase et lequel est le signal Q en quadrature.

Plus généralement, un mode de réalisation pallie tout ou partie des inconvénients des circuits connus dans lequel deux signaux en quadrature sont générés.

Par exemple, un mode de réalisation, prévoit un circuit apte à identifier quel est le signal I en phase et quel est le signal Q en quadrature parmi deux signaux en quadrature générés dans le circuit.

Un mode de réalisation prévoit un dispositif comprenant :
un premier circuit destiné à recevoir un premier signal sinusoïdal et un deuxième signal sinusoïdal en quadrature l'un par rapport à l'autre, le premier circuit étant configuré pour fournir :
   - un premier signal carré ayant un premier niveau si le premier signal sinusoïdal est positif par rapport à sa composante continue et un deuxième niveau sinon, et
   - un deuxième signal carré ayant un premier niveau si le deuxième signal sinusoïdal est positif par rapport à sa composante continue et un deuxième niveau sinon; et
une porte logique à commutation en courant configurée pour recevoir les premier et deuxième signaux carrés, et pour fournir :
   - un troisième signal carré à un premier niveau et un quatrième signal carré à un deuxième niveau quand les premier et deuxième signaux carrés sont simultanément à leurs premier niveaux et que le premier signal carré est en avance de phase sur le deuxième signal carré ; et
   - le troisième signal carré à un deuxième niveau et le quatrième signal carré à un premier niveau quand les premier et deuxième signaux carrés sont simultanément à leurs premier niveaux et que le deuxième signal carré est en avance de phase sur le premier signal carré.

Selon un mode de réalisation, la porte logique est configurée pour que :
- le troisième signal carré commute de son premier niveau à son deuxième niveau uniquement lorsque le deuxième signal carré commute de son deuxième niveau à son premier niveau pendant le premier niveau du premier signal carré, le troisième signal carré restant ensuite à son deuxième niveau uniquement tant que les premier et deuxième signaux carrés restent à leurs premiers niveaux ; et
- le quatrième signal carré commute de son premier niveau à son deuxième niveau uniquement lorsque le premier signal carré commute de son deuxième niveau à son premier niveau pendant le premier niveau du deuxième signal carré, le quatrième signal carré restant ensuite à son deuxième niveau uniquement tant que les premier et deuxième signaux carré restent à leurs premiers niveaux.

Selon un mode de réalisation :
le premier circuit comprend deux circuits de conversion identiques, chaque circuit de conversion comprenant:
   - un noeud d'entrée et un noeud de sortie,
   - un inverseur ayant une sortie couplée au noeud de sortie,
   - une résistance couplant une entrée de l'inverseur à la sortie de l'inverseur, et
   - une capacité couplant le noeud d'entrée à l'entrée de l'inverseur ;
le noeud d'entrée et le noeud de sortie d'un des deux circuits de conversion sont configurés pour respectivement recevoir le premier signal sinusoïdal et fournir le premier signal carré ; et
le noeud d'entrée et le noeud de sortie de l'autre des deux circuits de conversion sont configurés pour respectivement recevoir le deuxième signal sinusoïdal et fournir le deuxième signal carré.

Selon un mode de réalisation, chaque circuit de conversion comprend en outre :
un premier interrupteur en série avec ladite résistance, entre l'entrée et la sortie de l'inverseur ; et
un deuxième interrupteur couplant l'entrée de l'inverseur à une tension apte à forcer un état donné de la sortie de l'inverseur quand le deuxième interrupteur est fermé.

Selon un mode de réalisation, ladite porte logique comprend :
un noeud de référence, un noeud d'alimentation et des premier, deuxième, troisième, quatrième, cinquième et sixième noeuds ; un premier transistor connecté entre le noeud de référence et ledit premier noeud et ayant une grille configurée pour recevoir un premier signal de commande déterminé par le premier signal carré ;
un deuxième transistor connecté entre lesdits premier et deuxième noeuds et ayant une grille connectée audit troisième noeud ;
une première résistance couplant ledit deuxième noeud audit noeud d'alimentation ;
un troisième transistor connecté entre lesdits premier et troisième noeuds et ayant une grille connectée audit quatrième noeud ;
une deuxième résistance couplant ledit troisième noeud audit noeud d'alimentation ;
un quatrième transistor connecté entre ledit noeud de référence et ledit cinquième noeud et ayant une grille configurée pour recevoir un deuxième signal de commande déterminé par le deuxième signal carré ;
un cinquième transistor connecté entre lesdits cinquième et quatrième noeuds et ayant une grille connectée audit sixième noeud ;
un troisième résistance couplant ledit sixième noeud audit noeud d'alimentation ;
un sixième transistor connecté entre lesdits cinquième et sixième noeuds et ayant une grille connectée audit deuxième noeud ; et
une quatrième résistance couplant ledit quatrième noeud audit noeud d'alimentation,
lesdits deuxième et quatrième noeuds étant configurés pour fournir respectivement les troisième et quatrième signaux carrés.

Selon un mode de réalisation, ladite porte logique comprend en outre deux circuits de commande identiques comprenant chacun une entrée et une sortie, chaque circuit de commande étant configuré pour fournir, sur sa sortie, un signal carré ayant une composante alternative déterminée par la composante alternative d'un signal carré reçu sur son entrée et pour fixer une composante alternative du signal fourni sur sa sortie, un premier des deux circuits de commande étant configuré pour recevoir le premier signal carré sur son entrée et pour fournir le premier signal de commande sur sa sortie et un deuxième des deux circuits de commande étant configuré pour recevoir le deuxième signal carré sur son entrée et pour fournir le deuxième signal de commande sur sa sortie.

Selon un mode de réalisation, le premier circuit est en outre destiné à recevoir un troisième signal sinusoïdal en opposition de phase avec le premier signal sinusoïdal et un quatrième signal sinusoïdal en opposition de phase avec le deuxième signal sinusoïdal, le premier circuit étant en outre configuré pour fournir :
- un cinquième signal carré ayant un premier niveau si le troisième signal sinusoïdal est positif par rapport à sa composante continue et un deuxième niveau sinon, et
- un sixième signal carré ayant un premier niveau si le quatrième signal sinusoïdal est positif par rapport à sa composante continue et un deuxième niveau sinon.

Selon un mode de réalisation, chacun des deux circuits de commande comprend :
- une entrée supplémentaire,
- des premier, deuxième et troisième noeuds, le troisième noeud étant couplé à la sortie dudit circuit de commande,
- un premier transistor connecté entre le noeud de référence et le premier noeud dudit circuit de commande et ayant une grille configurée pour recevoir une première tension de polarisation,
- un deuxième transistor connecté entre les premier et deuxième noeuds dudit circuit de commande et ayant une grille couplée à l'entrée dudit circuit de commande,
- une première résistance couplant le deuxième noeud dudit circuit de commande au noeud d'alimentation,
- un troisième transistor connecté entre les premier et troisième noeuds dudit circuit de commande et ayant une grille couplée à l'entrée supplémentaire dudit circuit de commande, et
- une deuxième résistance couplant le troisième noeud dudit circuit de commande au noeud d'alimentation ;
l'entrée supplémentaire du premier circuit de commande est configurée pour recevoir le cinquième signal carré ; et l'entrée supplémentaire du deuxième circuit de commande est configuré pour recevoir le sixième signal carré.

Selon un mode de réalisation, chaque circuit de commande comprend en outre :
une première capacité couplant l'entrée dudit circuit de commande à la grille du deuxième transistor dudit circuit de commande ;
une troisième résistance couplant la grille du deuxième transistor dudit circuit de commande à un quatrième noeud dudit circuit de commande, ledit quatrième noeud étant configuré pour recevoir une première tension continue ;
une deuxième capacité couplant l'entrée supplémentaire dudit circuit de commande à la grille du troisième transistor dudit circuit de commande ;
une quatrième résistance couplant la grille du troisième transistor dudit circuit de commande audit quatrième noeud ; une troisième capacité couplant le troisième noeud dudit circuit de commande à la sortie dudit circuit de commande ; et
une cinquième résistance couplant la sortie dudit circuit de commande à un cinquième noeud dudit circuit de commande, ledit cinquième noeud étant configuré pour recevoir une deuxième tension continue.

Selon un mode de réalisation :
le dispositif comprend en outre un circuit d'écriture et de mémorisation à commutation en courant comprenant :
   - une première entrée configurée pour recevoir le troisième signal carré,
   - une deuxième entrée configurée pour recevoir le quatrième signal carré,
   - une première sortie configurée pour fournir un premier signal de sortie, et
   - une deuxième sortie configurée pour fournir un deuxième signal de sortie; et
le circuit d'écriture et de mémorisation est configuré de sorte qu'un niveau des premier et deuxième signaux de sortie est déterminé par le niveau respectivement des troisième et quatrième signaux carrés quand les premier et deuxième signaux carrés sont simultanément à leurs premiers niveaux, et pour mémoriser le niveau des premier et deuxième signaux de sortie sinon.

Selon un mode de réalisation :
le circuit d'écriture et de mémorisation comprend une première bascule à commutation en courant et une deuxième bascule à commutation en courant ;
la première bascule est configurée pour recevoir le troisième signal carré et fournir le premier signal de sortie ; et
la deuxième bascule est configurée pour recevoir le quatrième signal carré et fournir le deuxième signal de sortie.

Selon un mode de réalisation :
chacune des première et deuxième bascules comprend :
- un noeud de référence, un noeud d'alimentation et des premier, deuxième, troisième et quatrième noeuds,
- un circuit à commutation en courant configuré pour recevoir un signal et pour fournir un signal en phase avec le signal reçu et un signal en opposition de phase avec le signal reçu,
- un premier transistor connecté entre ledit noeud de référence et ledit premier noeud, une grille dudit premier transistor étant configurée pour recevoir un signal indiquant quand les premier et deuxième signaux carrés sont simultanément à leurs premiers niveaux,
- un deuxième transistor connecté entre lesdits premier et deuxième noeuds et ayant une grille configurée pour recevoir le signal en phase,
- une première résistance couplant ledit deuxième noeud au noeud d'alimentation,
- un troisième transistor connecté entre lesdits premier et troisième noeuds et ayant une grille configurée pour recevoir le signal en opposition de phase,
- une deuxième résistance couplant ledit troisième noeud au noeud d'alimentation,
- des quatrième, cinquième et sixième transistors connectés chacun entre le noeud de référence et ledit quatrième noeud, une grille du quatrième transistor étant configurée pour recevoir un signal indiquant quand les premier et deuxième signaux carrés sont simultanément à leurs deuxièmes niveaux, une grille du cinquième transistor étant configurée pour recevoir un signal indiquant quand les premier et deuxième signaux carrés sont simultanément et respectivement à leur premier niveau et à leur deuxième niveau, et une grille du sixième transistor étant configurée pour recevoir un signal indiquant quand les premier et deuxième signaux carrés sont simultanément et respectivement à leur deuxième niveau et leur premier niveau,
- un septième transistor connecté entre lesdits quatrième et deuxième noeuds et ayant une grille connectée audit troisième noeud, et
- un huitième transistor connecté entre lesdits quatrième et troisième noeuds et ayant une grille connecté audit deuxième noeud ;
   le circuit à commutation en courant de la première bascule est configuré pour recevoir le troisième signal carré ;
   le circuit à commutation en courant de la deuxième bascule est configuré pour recevoir le quatrième signal carré;
   l'un des premier et deuxième noeuds de la première bascule est configuré pour fournir le premier signal de sortie ; et
   l'un des premier et deuxième noeuds de la deuxième bascule est configuré pour fournir le deuxième signal de sortie.

Selon un mode de réalisation, chaque circuit à commutation en courant comprend :
- un noeud de référence, un noeud d'alimentation et des premier, deuxième et troisième noeuds ;
- un premier transistor MOS connecté entre ledit noeud de référence et ledit premier noeud et ayant une grille configurée pour recevoir une tension de polarisation;
- un deuxième transistor MOS connecté entre lesdits premier et deuxième noeuds et ayant une grille configurée pour recevoir le signal reçu par ledit circuit à commutation en courant ;
- un troisième transistor MOS connecté entre lesdits premier et troisième noeuds et ayant une grille connectée audit deuxième noeud ;
- une résistance couplant ledit deuxième noeud audit noeud d'alimentation ; et
- une autre résistance couplant ledit troisième noeud audit noeud d'alimentation,
lesdits deuxième et troisième noeuds étant configurés pour fournir respectivement les signaux en opposition de phase et en phase fournis par ledit circuit à commutation en courant.

Selon un mode de réalisation, le circuit d'écriture et de mémorisation comprend en outre une porte logique à commutation en courant configurée pour fournir le signal indiquant quand les premier et deuxième signaux carrés sont à leurs premiers niveaux, le signal indiquant quand les premier et deuxième signaux carrés sont à leurs deuxièmes niveaux, le signal indiquant quand les premier et deuxième signaux carrés sont respectivement à leurs premier et deuxième niveaux, et le signal indiquant quand les premier et deuxième signaux carrés sont respectivement à leurs deuxième et premier niveaux.

Selon un mode de réalisation, le circuit d'écriture et de mémorisation comprend en outre une porte logique à commutation en courant configurée pour recevoir les premier, deuxième, cinquième et sixième signaux carrés et pour fournir, à partir desdits signaux reçus, le signal indiquant quand les premier et deuxième signaux carrés sont à leurs premiers niveaux, le signal indiquant quand les premier et deuxième signaux carrés sont à leurs deuxièmes niveaux, le signal indiquant quand les premier et deuxième signaux carrés sont respectivement à leurs premier et deuxième niveaux, et le signal indiquant quand les premier et deuxième signaux carrés sont respectivement à leurs deuxième et premier niveaux.

Selon un mode de réalisation, la porte logique du circuit d'écriture et de mémorisation comprend :
une porte NON-ET à commutation en courant configurée pour revoir quatre signaux déterminés par respectivement par les premier, deuxième, quatrième et cinquième signaux carrés et
pour fournir des premier, deuxième, troisième et quatrième signaux de sortie ; et
quatre inverseurs configurés pour recevoir respectivement les quatre signaux de sortie de la porte logique NON-ET et pour fournir respectivement le signal indiquant quand les premier et deuxième signaux carrés sont à leurs premiers niveaux, le signal indiquant quand les premier et deuxième signaux carrés sont à leurs deuxièmes niveaux, le signal indiquant quand les premier et deuxième signaux carrés sont respectivement à leurs premier et deuxième niveaux, et le signal indiquant quand les premier et deuxième signaux carrés sont respectivement à leurs deuxième et premier niveaux.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme de blocs, un exemple d'un circuit utilisant des signaux I et Q ;
la figure 2 représente, sous la forme de blocs, un mode de réalisation d'un circuit de détection de signaux I et Q ;
la figure 3 illustre par des chronogrammes un exemple d'un mode de fonctionnement du circuit de la figure 2 ;
la figure 4 représente un exemple d'un mode de réalisation d'un circuit du détecteur de la figure 2 ;
la figure 5 représente un exemple d'un mode de réalisation d'un circuit du détecteur de la figure 2 ;
la figure 6 représente un exemple d'un mode de réalisation d'une partie du circuit de la figure 5 ;
la figure 7 représente un autre exemple d'un mode de réalisation d'une partie du circuit de la figure 5 ;
la figure 8 représente sous la forme de blocs, une variante de mode de réalisation du circuit de détection de signaux de la figure 2 ;
la figure 9 représente un exemple d'un mode de réalisation d'une partie du circuit de la figure 8 ; et
la figure 10 représente un exemple d'un mode de réalisation d'une partie du circuit de la figure 8.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les fonctionnalités usuelles mises en oeuvre avec des signaux I et Q n'ont pas été détaillées, les modes de réalisation décrits étant compatibles avec ces fonctionnalités usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, lorsqu'il est indiqué qu'un signal a un premier niveau et un deuxième niveau, par exemple un niveau haut et un niveau bas, cela signifie que le signal alterne entre le premier niveau et le deuxième niveau étant entendu que, en pratique, chaque niveau peut correspondre à une tension ou à un courant qui peuvent ne pas être parfaitement constants. Un tel signal est, par exemple, appelé signal carré.

Dans un circuit récepteur Ultra Large Bande, en raison de la fréquence du signal reçu, il est complexe, voire impossible, de générer avec un même oscillateur, par exemple avec un unique oscillateur commandé en tension (VCO de l'anglais Voltage Controlled Oscillator), les deux signaux d'oscillateur local I et Q utilisés pour générer les deux signaux en bande de base. Cela est vrai à plus forte raison quand on souhaite que le circuit récepteur fonctionne sur plusieurs, voire tous, les canaux du standard UWB.

Une solution pour générer les signaux d'oscillateur local I et Q est alors d'utiliser deux oscillateurs interconnectés, c'est-à-dire couplés l'un avec l'autre, configurés pour qu'un premier des deux oscillateurs fournisse le signal I et l'autre fournisse le signal Q. Un exemple de deux oscillateurs contrôlés en tension permettant de générer deux signaux sinusoïdaux en quadrature l'un par rapport à l'autre est décrit dans l'article "900 MHz CMOS LC-Oscillator with Quadrature Outputs" de Rofougaran et al publié en 1996, dans IEEE International Solid-State Circuits Conférence (ISSCC) .

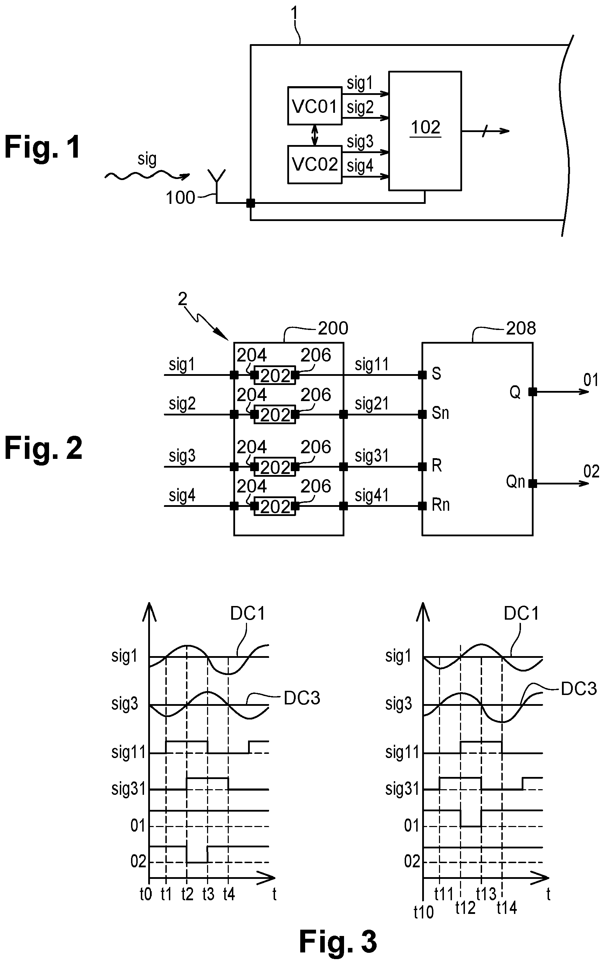

La figure 1 représente, sous la forme de blocs, un exemple d'un circuit ou dispositif 1 fournissant et utilisant des signaux I et Q, dans lequel les signaux I et Q sont deux signaux d'oscillateur local générés par deux oscillateurs en quadrature.

Dans cet exemple, le dispositif 1 est un dispositif de réception d'un signal sig sans fil Ultra Large Bande. Le signal sig est reçu par une antenne 100 qui le transmet à un circuit 102 de traitement. A titre d'exemple, le circuit 102 comprend un circuit translateur de fréquence (non représenté) configuré pour générer deux signaux en bande de base en mélangeant le signal sig reçu avec les deux signaux d'oscillateur local I et Q.

Pour générer les deux signaux I et Q, le dispositif 1 comprend deux oscillateurs commandés en tension VCO1 et VCO2. Les oscillateurs VCO1 et VCO2 sont couplés l'un à l'autre et sont commandés de sorte à fournir des signaux sinusoïdaux à une fréquence déterminée par la fréquence de la porteuse du signal sig, la fréquence des signaux d'oscillateur locaux est, par exemple, proche de la fréquence porteuse du signal sig, voire égale à celle-ci. Par exemple, les oscillateurs VCO1 et VCO2 font partie d'une boucle à verrouillage de phase (non représentée) configurée pour que la fréquence des signaux générés par les oscillateurs VCO1 et VCO2 soit déterminée par la fréquence de la porteuse du signal sig..

L'oscillateur VCO1, respectivement VCO2, est configuré pour fournir un signal sinusoïdal sig1, respectivement sig3, les signaux d'oscillateur local sig1 et sig3 étant en quadrature l'un avec l'autre. En pratique, l'oscillateur VCO1, respectivement VCO2, fournit également un signal sinusoïdal sig2, respectivement sig4, en opposition de phase avec le signal sig1, respectivement sig3.

Les signaux sig1 et sig3 sont fournis au circuit 102, les signaux sig2 et sig3 pouvant également être fournis au circuit 102.

Un problème qui se pose dans le dispositif 1 est que celui des signaux sig1 et sig3 qui est le signal I n'est pas déterminé et dépend du démarrage des oscillateurs VCO1 et VCO2 .

Il est connu d'avoir des séquences de démarrage différentes entre les oscillateurs VCO1 et VCO2, de manière à forcer l'un des deux signaux sig1 et sig3 à être le signal I. Toutefois, cela augmente le temps nécessaire à la stabilisation des deux oscillateurs VCO1 et VCO2 à chaque démarrage ou changement de fréquence porteuse.

Il est également connu d'ajouter une erreur de phase dans l'un des deux oscillateurs VCO1 et VCO2 de manière à forcer l'un des deux signaux sig1 et sig3 à être le signal I. Toutefois, l'introduction d'une erreur de phase n'est pas souhaitable, par exemple car cela conduit à une erreur sur la distance déterminée par le dispositif 1 à partir du signal sig et des signaux I et Q.

Il est aussi connu d'introduire une différence entre des courants de polarisation des deux oscillateurs VCO1 et VCO2 de manière à forcer l'un des deux signaux sig1 et sig3 à être le signal I. Toutefois, cela résulte en une différence d'amplitude entre les signaux sig1 et sig3, ce qui n'est pas souhaitable.

Il est ici proposé un circuit de détection de signaux I et Q permettant de déterminer parmi les signaux sig1 et sig3 celui qui est le signal I et celui qui est le signal Q, sans introduire de déséquilibre entre les deux oscillateurs VCO1 et VCO2 contrairement à ce qui est fait dans les solutions connues décrites ci-dessus.

Le circuit proposé est destiné recevoir les signaux sig1 et sig3, peut être destiné à recevoir également les signaux sig2 et sig4, et est configuré pour fournir deux signaux O1 et O2 à partir desquels il est possible d'identifier, après le démarrage des oscillateurs VCO1 et VCO2, si les signaux sig1 et sig3 correspondent respectivement aux signaux I et Q ou respectivement aux signaux Q et I. Ainsi, à partir des deux signaux O1 et 02, le circuit de traitement 102 peut commuter entre une configuration où il utilise les signaux sig1 et sig3 comme signaux I et Q respectivement, et une configuration où il utilise les signaux sig1 et sig3 comme signaux Q et I respectivement.

La figure 2 représente, sous la forme de blocs, un mode de réalisation d'un circuit ou dispositif 2 de détection de signaux I et Q.

Le dispositif 2 comprend un circuit 200 configuré pour convertir les signaux sinusoïdaux sig1 et sig3 en deux signaux carrés correspondants sig11 et sig31.

Le circuit 200 est configuré pour recevoir les signaux sig1 et sig3 en quadrature l'un avec l'autre. Le circuit 200 est configuré pour fournir le signal sig11 à un premier niveau, par exemple haut, lorsque le signal sig1 est positif par rapport à sa composante continue (DC de l'anglais Direct Current), c'est-à-dire lorsque la valeur du signal sig1 est supérieure à la valeur de sa composante continue, et à un deuxième niveau, par exemple bas, lorsque le signal sig1 est négatif par rapport à sa composante continue, c'est-à-dire lorsque la valeur du signal sig1 est inférieure à la valeur de sa composante continue. Le circuit 200 est en outre configuré pour fournir le signal sig31 à un premier niveau, par exemple haut, lorsque le signal sig3 est positif par rapport à sa composante continue et à un deuxième niveau, par exemple bas, lorsque le signal sig3 est négatif par rapport à sa composante continue. De préférence, les premiers niveaux des signaux carrés sig11 et sig31 correspondent à une même première valeur de tension, et les deuxièmes niveaux des signaux carrés sig11 et sig31 correspondent à une même deuxième valeur de tension.

Selon un mode de réalisation, le circuit 200 comprend deux circuits 202 identiques configurés chacun pour convertir un signal sinusoïdal en un signal carré correspondant. Ainsi, chaque circuit 202 comprend une entrée 204 configurée pour recevoir un signal sinusoïdal et une sortie 206 configurée pour fournir le signal carré correspondant.

Plus particulièrement, l'un des deux circuits 202 est configuré pour recevoir le signal sig1 sur son entrée 204 et pour fournir le signal sig11 sur sa sortie 206, l'autre des deux circuits 202 étant configuré pour recevoir le signal sig3 sur son entrée 204 et pour fournir le signal sig31 sur sa sortie 206.

Le dispositif 2 comprend en outre une porte logique 208. La porte logique 208 est mise en oeuvre en technologie CML (de l'anglais Current Mode Logic - logique à commutation en courant). Dit autrement, la porte 208 est une porte logique à commutation en courant. La porte 208 est configurée pour recevoir les signaux sig11 et sig31, par exemple sur des entrées respectives S et R. La porte 208 est en outre configurée pour fournir les deux signaux O1 et O2, par exemple sur des sorties respectives Q et Qn. Les signaux O1 et O2 sont des signaux carrés. Les commutations des signaux O1 et O2 entre leurs deux niveaux sont déterminées par l'ordre d'arrivée, c'est-à-dire la séquence, et le sens des commutations des signaux sig11 et sig31 sur la porte logique 208. Les deux signaux O1 et O2 sont deux signaux permettant de déterminer lequel des signaux sig1 et sig3 est le signal I.

Selon un mode de réalisation, la porte 208 est configurée pour que les signaux O1 et O2 soient respectivement à un premier niveau, par exemple haut, et à un deuxième niveau, par exemple bas, lorsque les deux signaux sig11 et sig31 sont à leurs premiers niveaux, par exemple hauts, et que les signaux sig11 et sig31 (donc les signaux sig1 et sig3) sont les signaux respectivement I et Q. De manière complémentaire, la porte 208 est en outre configurée pour que les signaux O1 et O2 soient respectivement à un deuxième niveau, par exemple bas, et à un premier niveau, par exemple haut, lorsque les deux signaux sig11 et sig31 sont à leurs premiers niveaux (par exemple hauts) et que les signaux sig11 et sig31 (donc les signaux sig1 et sig3) sont les signaux respectivement Q et I. De préférence, la porte 208 est en outre configurée pour que les signaux O1 et O2 soient à leurs premiers niveaux, par exemple haut, lorsque les signaux sig11 et sig31 sont simultanément à leurs deuxièmes niveaux, par exemple bas.

Selon un mode de réalisation, la porte 208 est plus particulièrement configurée pour que le signal O1 (sortie Q) commute d'un premier niveau, par exemple haut, à un deuxième niveau, par exemple bas, uniquement lorsque le signal sig11 (entrée S) commute de son deuxième niveau à son premier niveau alors que le signal sig31 (entrée R) est à son premier niveau. En outre, suite à une telle commutation du signal O1, la porte 208 est configurée pour maintenir le signal O1 à son deuxième niveau uniquement tant que les deux signaux sig11 et sig31 restent à leurs premiers niveaux. La porte 208 est, par exemple, configurée pour que le signal O1 soit à son premier niveau dans tous les autres cas. De manière symétrique ou complémentaire, la porte 208 est en outre configurée pour que le signal O2 (sortie Qn) commute d'un premier niveau, par exemple haut, à un deuxième niveau, par exemple bas, uniquement lorsque le signal sig31 (entrée R) commute de son deuxième niveau à son premier niveau alors que le signal sig11 (entrée S) est à son premier niveau. En outre, suite à une telle commutation du signal O2, la porte 208 est configurée pour maintenir le signal O2 à son deuxième niveau uniquement tant que les deux signaux sig11 et sig31 restent à leurs premiers niveaux. La porte 208 est, par exemple, configurée pour que le signal O2 soit à son premier niveau dans tous les autres cas.

De préférence, les premiers niveaux des signaux carrés O1 et O2 correspondent à une même première valeur de tension, et les deuxièmes niveaux des signaux carrés O1 et O2 correspondent à une même deuxième valeur de tension.

La figure 3 illustre par des chronogrammes un exemple d'un mode de fonctionnement du circuit de la figure 2. Dans l'exemple de la figure 3, les premiers niveaux des signaux sig11, sig31, O1 et O2 sont des niveaux hauts, les deuxièmes niveaux des signaux sig11, sig31, O1 et O2 étant des niveaux bas. Plus particulièrement, cette figure 3 illustre le fonctionnement du circuit de la figure 2 dans le cas où le circuit 208 est configuré pour que le signal O1 commute à son deuxième niveau uniquement lorsque le signal sig11 commute à son premier niveau alors que le signal sig31 est à son premier niveau, le signal O2 commute à son deuxième niveau uniquement lorsque le signal sig31 commute à son premier niveau alors que le signal sig11 est à son premier niveau, les niveaux des signaux O1 et O2 soient maintenus quand les signaux sig11 et sig13 sont tous les deux à leurs premiers niveau, les signaux O1 et O2 soient à leurs premiers niveaux quand les signaux sig11 et sig31 sont simultanément à leurs deuxièmes niveaux.

La figure 3 illustre pour deux cas, respectivement à gauche et à droite en figure 3, l'allure des signaux sig1, sig3, sig11, sig31, O1 et O2. Le cas à gauche en figure 3 correspond au cas où les signaux sig1 et sig3 sont les signaux respectifs I et Q, le cas à droite en figure 3 correspondant au cas où les signaux sig1 et sig3 sont les signaux respectifs Q et I. En figure 3, la composante continue des signaux sig1 et sig3 est référencée respectivement DC1 et DC3.

A gauche en figure 3, à un instant t0, le signal sig1, respectivement sig3, a une valeur inférieure à sa composante continue DC1, respectivement DC3. Les signaux sig11 et sig31 sont alors à leurs deuxièmes niveaux. En outre, les signaux O1 et O2 sont alors à leurs premiers niveaux.

A un instant t1 postérieur à l'instant t0, le signal sig1, devient supérieur à sa composante continue DC1 alors que le signal sig3 est encore inférieur à sa composante continue DC3. Il en résulte que le signal sig11 commute à son premier niveau alors que le signal sig31 reste à son deuxième niveau. Les signaux O1 et O2 restent alors à leurs premiers niveaux.

A un instant t2 postérieur à l'instant t1, le signal sig3 devient supérieur à sa composante continue DC3 alors que le signal sig1 est encore supérieur à sa composante continue DC1. Il en résulte que le signal sig31 commute à son premier niveau alors que le signal sig11 est à son premier niveau. Cela entraîne que le signal O2 commute de son premier niveau à son deuxième niveau alors que le signal O1 reste à son premier niveau.

A un instant t3 postérieur à l'instant t2, le signal sig1 devient inférieur à sa composante continue DC1 alors que le signal sig3 est encore supérieur à sa composante continue DC3. Il en résulte que le signal sig11 commute à son deuxième niveau alors que le signal sig31 reste à son premier niveau. Ainsi, entre les instants t2 et t3, le signal O2 est maintenu à son deuxième niveau et le signal O1 reste à son premier niveau, et, en outre, à l'instant t3 le signal O2 commute à son premier niveau.

A un instant t4 postérieur à l'instant t3, le signal sig3 devient inférieur à sa composante continue DC3 alors que le signal sig1 est encore inférieur à sa composante continue DC1. Il en résulte que le signal sig31 commute à son deuxième niveau alors que le signal sig11 reste à son deuxième niveau.

Après l'instant t4, les signaux sig1, sig3, sig11, sig31, O1 et O2 sont dans la même configuration qu'à l'instant t0, et les commutations décrites en relation avec les instants successifs t1, t2, t3 et t4 se répètent pour les périodes suivantes des signaux sig1 et sig2.

A droite en figure 3, à un instant t10, les signaux sig1, sig3, sig11, sig31, O1 et O2 sont dans la même configuration que celle décrite en relation avec l'instant t0.

A un instant t11 postérieur à l'instant t10, le signal sig3 devient supérieur à sa composante continue DC3 alors que le signal sig1 est encore inférieur à sa composante continue DC1. Il en résulte que le signal sig31 commute à son premier niveau alors que le signal sig11 reste à son deuxième niveau. Les signaux O1 et O2 restent alors à leurs premiers niveaux.

A un instant t12 postérieur à l'instant t11, le signal sig1 devient supérieur à sa composante continue DC1 alors que le signal sig3 est encore supérieur à sa composante continue DC3. Il en résulte que le signal sig11 commute à son premier niveau alors que le signal sig31 est à son premier niveau. Cela entraîne que le signal O1 commute de son premier niveau à son deuxième niveau alors que le signal O2 reste à son premier niveau.

A un instant t13 postérieur à l'instant t12, le signal sig3 devient inférieur à sa composante continue DC3 alors que le signal sig1 est encore supérieur à sa composante continue DC1. Il en résulte que le signal sig31 commute à son deuxième niveau alors que le signal sig11 reste à son premier niveau. Ainsi, entre les instants t12 et t13, le signal O1 est maintenu à son deuxième niveau, le signal O2 reste à son premier niveau, et, en outre, à l'instant t13 le signal O1 commute à son premier niveau.

A un instant t14 postérieur à l'instant t13, le signal sig1 devient inférieur à sa composante continue DC1 alors que le signal sig3 est encore inférieur à sa composante continue DC3. Il en résulte que le signal sig11 commute à son deuxième niveau alors que le signal sig31 reste à son deuxième niveau.

Après l'instant t14, les signaux sig1, sig3, sig11, sig31, O1 et O2 sont dans la même configuration qu'à l'instant t10, et les commutations décrites en relation avec les instants successifs t11, t12, t13 et t14 se répètent pour les périodes suivantes des signaux sig1 et sig3.

Comme le montre la figure 3, quand les signaux sig11 et sig31 sont tous les deux à leurs premiers niveaux :
- les signaux O1 et O2 sont respectivement à leurs premier et deuxième niveaux si les signaux sig1 et sig3 sont les signaux respectivement I et Q, et, à l'inverse,
- les signaux O1 et O2 sont respectivement à leurs deuxième et premier niveaux si les signaux sig1 et sig3 sont les signaux respectivement Q et I.

Les niveaux des signaux O1 et O2 quand les signaux sig11 et sig31 sont à leurs premiers niveaux permettent donc de déterminer lequel des signaux sig1 et sig3 est le signal I et le signal Q.

En se référant de nouveau à la figure 2, de manière optionnelle, le circuit 200 est en outre configuré pour convertir les signaux sig2 et sig4 en deux signaux carrés correspondants sig21 et sig41. Le circuit 200 est alors configuré pour recevoir le signal sig2 en opposition de phase avec le signal sig1 et le signal sig4 en opposition de phase avec le signal sig3. Le circuit 200 est alors configuré pour fournir le signal sig21 à un premier niveau, par exemple haut, lorsque le signal sig2 est positif par rapport à sa composante continue et à un deuxième niveau, par exemple bas, lorsque le signal sig2 est négatif par rapport à sa composante continue, et pour fournir le signal sig41 à un premier niveau, par exemple haut, lorsque le signal sig4 est positif par rapport à sa composante continue et à un deuxième niveau, par exemple bas, lorsque le signal sig4 est négatif par rapport à sa composante continue. De préférence, les premiers niveaux des signaux carrés sig11, sig21, sig31 et sig41 correspondent à une même première valeur de tension, et les deuxièmes niveaux des signaux carrés sig11, sig21, sig31 et sig41 correspondent à une même deuxième valeur de tension.

Selon un mode de réalisation, le circuit 200 comprend deux circuits 202 supplémentaires pour fournir les signaux sig21 et sig41 à partir des signaux respectifs sig2 et sig4.

Plus particulièrement, l'un des deux circuits 202 supplémentaires est configuré pour recevoir le signal sig2 sur son entrée 204 et pour fournir le signal sig21 sur sa sortie 206, l'autre des deux circuits 202 supplémentaires étant configuré pour recevoir le signal sig4 sur son entrée 204 et pour fournir le signal sig41 sur sa sortie 206.

Selon un mode de réalisation, les signaux sig21 et sig41 sont fournis à la porte 208, par exemple à deux entrées respectives Sn et Rn de la porte 208. En effet, dans des modes de réalisation, la porte 208 utilise, en plus des signaux sig11 et sig31, les signaux sig21 et sig41 pour générer les signaux O1 et O2.

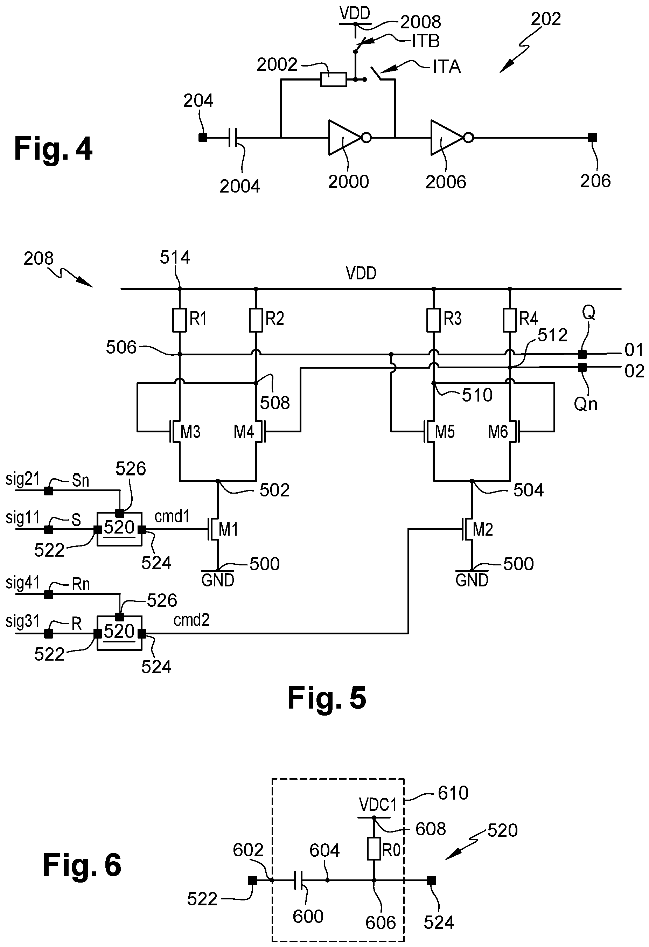

La figure 4 représente un exemple d'un mode de réalisation d'un circuit 202 de la figure 2.

Le circuit 202 comprend l'entrée, ou noeud d'entrée, 204 et la sortie, ou noeud de sortie, 206.

Le circuit 202 comprend un inverseur 2000. L'inverseur 2000 couple le noeud 204 au noeud 206. L'inverseur 2000 a, par exemple, une entrée couplée au noeud 204 et une sortie couplée au noeud 206.

Le circuit 202 comprend en outre une boucle de contre réaction résistive couplant la sortie de l'inverseur 2000 à l'entrée de l'inverseur 2000. La boucle de contre réaction est configurée pour que l'inverseur fonctionne à son point milieu.

Plus particulièrement, dans cet exemple, la boucle de contre réaction comprend une résistance 2002 couplant l'entrée et la sortie de l'inverseur 2000 entre elles. Par exemple, une borne de la résistance 2002 est couplée, de préférence connectée, à l'entrée de l'inverseur 2000, et une autre borne de la résistance 2002 est couplée à la sortie de l'inverseur 2000.

L'entrée de l'inverseur 2000 est couplée au noeud d'entrée 204 du circuit 202 par une capacité 2004. La capacité 2004 a, par exemple, une borne couplée, de préférence connectée, à l'entrée de l'inverseur 2000, et une autre borne couplée, de préférence connectée, au noeud 204.

Dans d'autres exemples non illustrés, la résistance 2002 est en série avec d'autres résistances entre l'entrée et la sortie de l'inverseur 2000. Par exemple une résistance supplémentaire peut être prévue entre l'interrupteur ITA et la sortie de l'inverseur 2000.

Selon un mode de réalisation, la sortie de l'inverseur 2000 est couplée au noeud 206 par un ou plusieurs inverseurs 2006 en série entre la sortie de l'inverseur 2000 et le noeud 206. Le ou les inverseurs 2006 sont dimensionnés de manière à adapter une valeur du courant que le circuit 202 est en mesure de fournir sur, ou tirer depuis, son noeud de sortie 206. Dans l'exemple de la figure 4, le circuit 202 a un nombre pair d'inverseurs en série entre ses noeuds 204 et 206, à savoir l'inverseur 2000 et un inverseur 2006, d'où il résulte que le signal sur le noeud 206 est à un niveau haut lorsque le signal sur le noeud 204 est positif par rapport à sa composante continue, et à un niveau bas sinon. Dans d'autres exemples non illustrés, ce nombre d'inverseurs peut être impair, d'où il résulte que le signal sur le noeud 206 est à un niveau bas, respectivement haut, quand le signal sur le noeud 204 est positif, respectivement négatif, par rapport à sa composante continue.

Dans une variante de réalisation, la sortie de l'inverseur 2000 est directement connectée au noeud 206, les inverseurs 2006 étant omis.

Selon un mode de réalisation, le circuit 202 comprend en outre un interrupteur ITA connecté en série avec la résistance 2002, entre l'entrée et la sortie de l'inverseur 2000. L'interrupteur 2002 est configuré pour sélectivement ouvrir ou fermer la boucle de contre réaction. Par exemple, l'interrupteur ITA couple la résistance 2002 à la sortie de l'inverseur 2000. Par exemple, l'interrupteur ITA a une borne de conduction couplée, par exemple connectée, à la sortie de l'inverseur 2000, et une autre borne de conduction couplée, par exemple connectée, à la résistance 2002. Dans un autre exemple non illustré, l'interrupteur ITA est connecté entre la résistance 2002 et l'entrée de l'inverseur 2000. Dans encore un autre exemple non illustré, en plus de la résistance 2002 entre l'entrée de l'inverseur 2000 et l'interrupteur ITA, la boucle de contre réaction comprend une autre résistance 2002 entre l'interrupteur ITA et la sortie de l'inverseur 2000.

Dans un mode de réalisation comprenant l'interrupteur ITA, le circuit 202 comprend en outre, de préférence, un interrupteur ITB couplant l'entrée de l'inverseur 2000 à un noeud 2008. Le noeud 2008 est configuré pour recevoir une tension apte à forcer la sortie de l'inverseur 2000 dans un état donné lorsque l'interrupteur ITB est passant et, de préférence, l'interrupteur ITA est bloqué. Par exemple, l'interrupteur ITB a une première borne de conduction couplée, de préférence connectée, au noeud 2008, et une deuxième borne de conduction couplée à l'entrée de l'inverseur 2000. Dans cet exemple, la deuxième borne de conduction de l'inverseur 2000 est couplée à l'entrée de l'inverseur 2000 par la résistance 2002. Dans un autre exemple non illustré, l'interrupteur ITB a une borne connectée à l'entrée de l'inverseur 2000. A titre d'exemple, la tension sur le noeud 2008 est une première tension VDD d'alimentation du circuit 202, et, plus généralement, du dispositif 2 (figure 2). La tension VDD est, par exemple, référencée à une deuxième tension d'alimentation (ou tension de référence), par exemple la masse GND, et est positive par rapport à cette dernière. Selon un autre exemple, la tension sur le noeud 2008 est la masse GND.

Les interrupteurs ITA et ITB permettent, une fois que les signaux O1 et O2 du dispositif 2 (figure 2) ont permis d'identifier lequel des signaux sig1 et sig3 est le signal I, de mettre le dispositif 2 dans un état constant (ou stationnaire), par exemple un état où les signaux sig11 et sig31 ne commutent plus. L'interrupteur ITA, respectivement ITB, est alors bloqué (ouvert), respectivement passant (fermé). Cet état stable du dispositif 2 permet de réduire la consommation, du fait qu'il n'y a plus de consommation dynamique résultant de commutations dans le dispositif 2. Le choix de la tension VDD ou GND sur le noeud 2008 dépend du nombre d'inverseurs 2006 et du niveau haut ou bas que l'on souhaite avoir sur le noeud 206 lorsque les interrupteurs ITA et ITB sont respectivement ouvert et fermé.

Dans une variante de réalisation l'un et/ou l'autre des interrupteurs ITA et ITB peuvent être omis.

A titre d'exemple, chaque inverseur 2000, 2006 du circuit 202 est mis en oeuvre en technologie CMOS (de l'anglais Complementary MOS - Métal Oxyde Semiconducteur Complémentaire). A titre d'exemple, chaque inverseur est alimenté par les tensions VDD et GND.

Les circuits 202 du circuit 200 (figure 2) sont, de préférence, identiques les uns aux autres.

La figure 5 représente un exemple d'un mode de réalisation du circuit 208 du dispositif 2 de la figure 2.

La porte 208 comprend les entrées R et S et les sorties Q et Qn. L'entrée S est configurée pour recevoir le signal sig11, l'entrée R étant configurée pour recevoir le signal sig31. La sortie Q est configurée pour fournir le signal O1, la sortie Qn étant configurée pour fournir le signal O2.

La porte 208 comprend un transistor MOS (de l'anglais Métal Oxide Semiconductor - Métal Oxyde Semiconducteur) M1. Le transistor M1 est connecté entre des noeuds 500 et 502 de la porte 208. Le noeud 500 est configuré pour recevoir une tension d'alimentation, la tension de référence GND dans cet exemple, le noeud 500 étant alors appelé noeud de référence. Par exemple, les bornes de conduction (source et drain) du transistor M1 sont couplées, de préférence connectées, aux noeuds respectifs 500 et 502. Dans cet exemple, le transistor M1 est à canal N et a sa source connectée au noeud 500, et son drain connecté au noeud 502.

La grille du transistor M1 est configurée pour recevoir un signal de commande cmd1, le signal cmd1 étant déterminé par le signal sig11. Par exemple, le signal cmd1 est un signal carré ayant un premier niveau, par exemple haut, lorsque le signal sig11 est à son premier niveau, et un deuxième niveau, par exemple bas, lorsque le signal sig11 est à son deuxième niveau.

De manière symétrique, la porte 208 comprend en outre un transistor MOS M2. Le transistor M2 est connecté entre le noeud 500 et un noeud 504 de la porte 208. Par exemple, les bornes de conduction du transistor M2 sont couplées, de préférence connectées, aux noeuds respectifs 500 et 504. Dans cet exemple, le transistor M2 est à canal N et a sa source connectée au noeud 500, et son drain connecté au noeud 504.

La grille du transistor M2 est configurée pour recevoir un signal de commande cmd2, le signal cmd2 étant déterminé par le signal sig31. Par exemple, le signal cmd2 est un signal carré ayant un premier niveau, par exemple haut, lorsque le signal sig31 est à son premier niveau, et un deuxième niveau, par exemple bas, lorsque le signal sig31 est à son deuxième niveau.

Ainsi, la composante alternative AC (de l'anglais Alternative Current - courant alternatif) de chacun des signaux cmd1 et cmd2 est déterminée par celle des signaux respectivement sig11 et sig31. A titre d'exemple, le signal cmd1, respectivement cmd2, a une composante continue configurée pour que le transistors M1, respectivement M2, fonctionne en saturation (transistor passant) lorsque le signal cmd1, respectivement cmd2, est à son premier niveau (haut dans cet exemple) et soit bloqué lorsque le signal cmd1, respectivement cmd2, est à son deuxième niveau (bas dans cet exemple).

De préférence, les transistors M1 et M2 ont des dimensions identiques.

La porte 208 comprend en outre quatre transistors MOS M3, M4, M5 et M6 connectés respectivement entre le noeud 502 et un noeud 506 de la porte 208, entre le noeud 502 et un noeud 508 de la porte 208, entre le noeud 504 et un noeud 510 de la porte 208, et entre le noeud 504 et un noeud 512 de la porte 208. En outre, la grille du transistor M3 est connectée au noeud 508, la grille du transistor M4 est connectée au noeud 512, la grille du transistor M5 est connectée au noeud 506 et la grille du transistor M6 est connectée au noeud 510.

Dans cet exemple, les transistors M3, M4, M5 et M6 sont à canal N et ont leurs sources connectées respectivement au noeud 502, au noeud 502, au noeud 504 et au noeud 504.

De préférence, les transistors M3, M4, M5 et M6 ont des dimensions identiques.

Les transistors M3 et M4 forment une paire différentielle polarisée par le transistor M1, les transistors M5 et M6 formant une autre paire différentielle polarisée par le transistor M2.

Les noeuds 506, 508, 510 et 512 sont couplés chacun à un noeud 514 de la porte 208, par une résistance respectivement R1, R2, R3 et R4. De préférence, les résistances R1, R2, R3 et R4 sont identiques. Le noeud 514 est configuré pour recevoir une tension d'alimentation différente de celle reçue par le noeud 500, le noeud 514 étant alors appelé noeud d'alimentation. Dans cet exemple, le noeud 514 est configuré pour recevoir la tension VDD référence à la masse GND et positive par rapport à la masse GND.

Dans ce mode de réalisation, qui correspond au fonctionnement décrit en relation avec la figure 3, le noeud 506 est connecté à la sortie Q, et est configuré pour fournir le signal O1, et le noeud 512 est connecté à la sortie Qn et est configuré pour fournir le signal O2.

Ainsi, dans le circuit 208 de la figure 5, si le signal cmd1, respectivement cmd2, est à son deuxième niveau, par exemple bas, alors le signal O1, respectivement O2, est à son premier niveau, par exemple haut. En outre, si le signal cmd1, respectivement cmd2, commute à son premier niveau, par exemple haut, alors que le signal cmd2, respectivement cmd1, est déjà à son premier niveau, par exemple haut, le signal O1, respectivement O2, commute à son deuxième niveau, par exemple bas, le signal O2, respectivement O1, restant à son premier niveau, par exemple haut.

Pour fournir les signaux cmd1 et cmd2 aux transistors respectifs M1 et M2 à partir des signaux respectifs sig11 et sig31, la porte 208 comprend deux circuits 520 identiques. Les circuits 520 sont, par exemple, des circuits de mise en forme d'un signal reçu en un signal de commande ou, dit autrement, des circuits de commande rapprochée ("driver" en anglais). Dit autrement, chaque circuit 520 est configuré pour adapter les premier et deuxième niveaux du signal de commande qu'il fournit, par exemple pour contrôler le courant circulant le transistor que ce signal commande. Chaque circuit 520 comprend une entrée 522 et une sortie 524. Un des circuits 520 a son entrée 522 connectée à l'entrée S et sa sortie 524 connectée à la grille du transistor M1, l'autre des circuits 520 a son entrée 522 connectée à l'entrée R et sa sortie 524 connectée à la grille du transistor M2. Dit autrement, l'un des circuits 520 est configuré pour recevoir le signal sig11 (sur son entrée 522) et pour fournir le signal cmd1 (sur sa sortie 524), l'autre des circuits étant configuré pour recevoir le signal sig31 (sur son entrée 522) et pour fournir le signal cmd2 (sur sa sortie 524). Chaque circuit 520 est configuré pour que le signal carré fourni sur sa sortie 524 ait une composante alternative déterminée par la composante alternative du signal qu'il reçoit sur son entrée 522, et, en outre, pour fixer ou déterminer la composante continue du signal qu'il fournit sur sa sortie 524. De préférence, chaque circuit 520 est configuré pour fournir un signal sur sa sortie 524 au niveau haut quand le signal sur son entrée 522 est au niveau haut, et un signal sur sa sortie 524 au niveau bas quand le signal sur son entrée 522 est au niveau bas.

Selon un mode de réalisation, par exemple un mode de réalisation où le circuit 200 (figure 2) est configuré pour fournir également les signaux sig21 et sig41, chaque circuit 520 est configuré pour recevoir, en plus du signal carré sur son entrée 520, un signal carré sur une entrée 526, les signaux sur les entrées 522 et 526 étant en opposition de phase l'un par rapport à l'autre. C'est par exemple le cas en figure 5 où l'un des circuits 520 reçoit les signaux sig11 (entrée S) et sig21 (entrée Sn) sur ses entrées respectives 522 et 526, et l'autre des circuits 520 reçoit les signaux sig31 (entrée R) et sig41 (entrée Rn) sur ses entrées respectives 522 et 526.

Dans une variante de réalisation, chaque circuit 520 est dépourvu de l'entrée 526.

Dans une variante de réalisation, le noeud 508 est connecté à la sortie Qn et est configuré pour fournir le signal O2, et le noeud 510 est connecté à la sortie Q et est configuré pour fournir le signal O1. Dans une telle variante, la porte 208 reste configurée pour que :
les signaux O1 et O2 soient respectivement à un premier niveau, par exemple haut, et à un deuxième niveau, par exemple bas, lorsque les deux signaux sig11 et sig31 sont à leurs premiers niveaux, par exemple hauts, et que les signaux sig11 et sig31 (donc les signaux sig1 et sig3) sont les signaux respectivement I et Q ; et
les signaux O1 et O2 soient respectivement à un deuxième niveau, par exemple bas, et à un premier niveau, par exemple haut, lorsque les deux signaux sig11 et sig31 sont à leurs premiers niveaux (par exemple hauts) et que les signaux sig11 et sig31 (donc les signaux sig1 et sig3) sont les signaux respectivement Q et I. De préférence, dans cette variante, la porte 208 reste en outre configurée pour que les signaux O1 et O2 soient à leurs premiers niveaux, par exemple haut, lorsque les signaux sig11 et sig31 sont simultanément à leurs deuxièmes niveaux, par exemple bas.

Plus particulièrement, dans cette variante, la porte 208 est configurée pour que :
- les signaux O1 et O2 soient à leurs premiers niveaux (par exemple hauts) lorsque les signaux sig11 et sig31 sont à leurs deuxièmes niveaux (par exemple bas) ;
- uniquement le signal O2 commute de son premier niveau (par exemple haut) à son deuxième niveau (par exemple bas) lorsque le signal sig11 (entrée S) commute de son deuxième niveau (par exemple bas) à son premier niveau (par exemple haut) alors que le signal sig31 (entrée R) est à son deuxième niveau (par exemple bas), les signaux O2 et O1 restant ensuite respectivement à leur deuxième niveau (par exemple bas) et à leur premier niveau (par exemple haut) jusqu'à ce que le signal sig11 commute de son premier niveau (par exemple haut) à son deuxième niveau (par exemple bas) alors que le signal sig31 est à son premier niveau (par exemple haut) ;
- le signal O2 commute à son premier niveau (par exemple haut) et que, par exemple, le signal O1 commute à son deuxième niveau (par exemple bas) lorsque le signal sig11 commute de son premier niveau (par exemple haut) à son deuxième niveau (par exemple bas) alors que le signal sig31 est à son premier niveau (par exemple haut) ;
- uniquement le signal O1 commute de son premier niveau (par exemple haut) à son deuxième niveau (par exemple bas) lorsque le signal sig31 (entrée R) commute de son deuxième niveau (par exemple bas) à son premier niveau (par exemple haut) alors que le signal sig11 (entrée S) est à son deuxième niveau (par exemple bas), les signaux O2 et O1 restant ensuite respectivement à leur premier niveau (par exemple haut) et à leur deuxième niveau (par exemple bas) jusqu'à ce que le signal sig31 commute de son premier niveau (par exemple haut) à son deuxième niveau (par exemple bas) alors que le signal sig11 est à son premier niveau (par exemple haut) ; et
- le signal O1 commute à son premier niveau (par exemple haut) et que, par exemple, le signal O2 commute à son deuxième niveau (par exemple bas) lorsque le signal sig31 commute de son premier niveau (par exemple haut) à son deuxième niveau (par exemple bas) alors que le signal sig11 est à son premier niveau (par exemple haut).

La figure 6 représente un exemple d'un mode de réalisation d'un circuit 520 de la porte 208 de la figure 5. Dans cet exemple, le circuit 520 est dépourvu d'entrée 526.

Le circuit 520 comprend une capacité 600 couplant l'entrée 522 à la sortie 524 du circuit 520. Par exemple, une première électrode 602 de la capacité 600 est connectée à l'entrée 522, et une deuxième électrode 604 de la capacité 600 est connecté à un noeud 606 lui-même connecté à la sortie 524 dans cet exemple. En outre, le circuit 520 comprend une résistance R0 couplant la sortie 524 à un noeud 608 configuré pour recevoir une tension continue, à savoir une tension VDC1 dans cet exemple. La tension continue du noeud 608 fixe, ou détermine, la composante continue du signal disponible sur la sortie 524 du circuit 520. Par exemple, la résistance R0 a une borne connectée au noeud 606 et une borne connectée au noeud 608.

A titre d'exemple, la capacité 600 et la résistance R0 forment un circuit 610 (délimité en trait pointillés en figure 6) ayant l'électrode (ou noeud) 602 comme entrée, le noeud 606 comme sortie et le noeud 608 configuré pour recevoir une tension continue déterminant la composante continue du signal sur la sortie 606 du circuit 610. Le circuit 610 est, par exemple, configuré pour transmettre un signal de son entrée 602 vers sa sortie 606 en adaptant la composant continue du signal transmis, c'est-à-dire en fixant la composante continue de sa sortie 606.

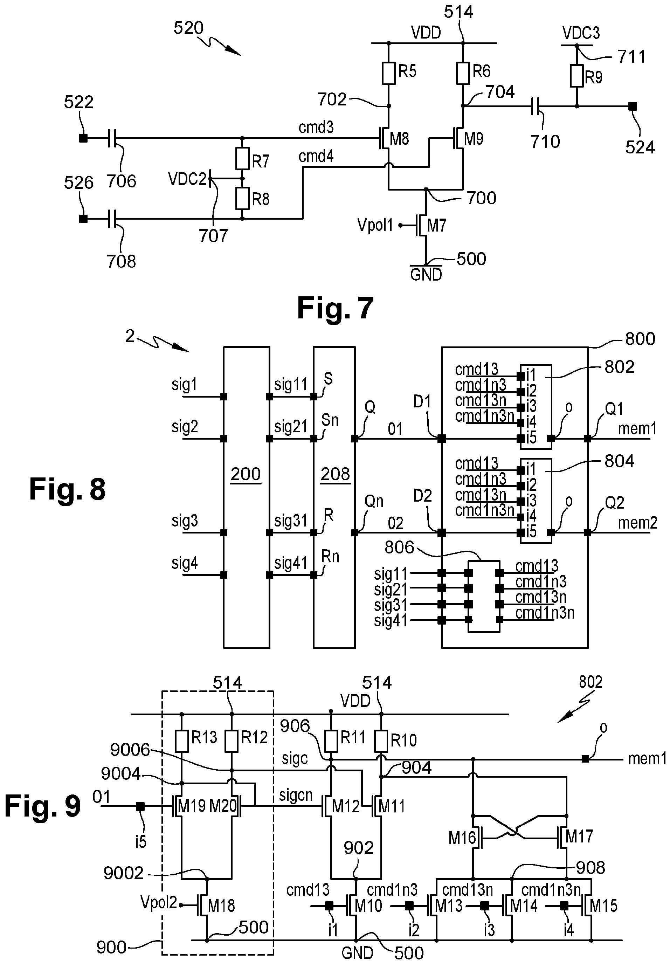

La figure 7 représente un autre exemple d'un mode de réalisation d'un circuit 520 de la porte 208 de la figure 5. Dans cet exemple, le circuit 520 comprend l'entrée 526.

Le circuit 520 comprend un transistor MOS M7 connecté entre le noeud de référence 500 et un premier noeud 700 du circuit 520. Le transistor M7 a ses bornes de conduction couplées, de préférence connectées, aux noeuds respectifs 500 et 700. Dans cet exemple, le transistor M7 est à canal N et a sa source connectée au noeud 500 et son drain connecté au noeud 700. Le transistor M7 a sa grille configurée pour recevoir une première tension de polarisation Vpol1. La tension Vpol1 est configurée pour le transistor M7 soit en saturation (passant).

Le circuit 520 comprend en outre un transistor MOS M8 connecté entre le noeud 700 et un noeud 702 du circuit 520. Le transistor M8 a ses bornes de conduction couplées, de préférence connectées, aux noeuds respectifs 700 et 702. Dans cet exemple, le transistor M8 est à canal N et a sa source connectée au noeud 700 et son drain connecté au noeud 702. La grille du transistor M8 est couplée à l'entrée 522 du circuit 520. Dit autrement, la grille du transistor M8 est configurée pour recevoir un signal de commande cmd3 déterminé par le signal reçu sur l'entrée 522 du circuit 520. Une résistance R5 du circuit 520 couple le noeud 702 au noeud d'alimentation 514. Par exemple, la résistance R5 a une borne couplée, de préférence connectée, au noeud 700 et une autre borne couplée, de préférence connectée, au noeud 702. Le signal cmd3 est configuré pour qu'un premier niveau du signal cmd3, par exemple haut, maintienne le transistor M8 en saturation (passant), et qu'un deuxième niveau du signal cmd3, par exemple bas, maintienne le transistor M8 bloqué.

De manière symétrique, le circuit 520 comprend en outre un transistor MOS M9 connecté entre le noeud 700 et un noeud 704 du circuit 520. Le transistor M9 a ses bornes de conduction couplées, de préférence connectées, aux noeuds respectifs 700 et 704. Dans cet exemple, le transistor M9 est à canal N et a sa source connectée au noeud 700 et son drain connecté au noeud 704. La grille du transistor M9 est couplée à l'entrée 526 du circuit 520. Dit autrement, la grille du transistor M9 est configurée pour recevoir un signal de commande cmd4 déterminé par le signal reçu sur l'entrée 526 du circuit 520. Une résistance R6 du circuit 520 couple le noeud 704 au noeud d'alimentation 514. Le signal cmd4 est configuré pour qu'un premier niveau du signal cmd4, par exemple haut, maintienne le transistor M9 en saturation (passant), et qu'un deuxième niveau du signal cmd4, par exemple bas, maintienne le transistor M9 bloqué.

De préférence, les transistors M8 et M9 ont les mêmes dimensions.

De préférence, les résistances R5 et R6 sont identiques, c'est-à-dire qu'elles ont les mêmes valeurs de résistance.

Le noeud 704 du circuit 520 est couplé à la sortie 524 du circuit 520. Dit autrement, le signal fourni par la sortie 524 du circuit 520 est déterminé par le signal sur le noeud 704.

Le transistor M7 permet de polariser une paire différentielle formée par les transistors M8 et M9. Ainsi, en fonction du niveau des signaux en opposition de phase présents sur les entrées 522 et 526 du circuit 520, le courant circulant dans le transistor M7 circule majoritairement dans le transistor M8 ou dans le transistor M9. Lorsque le courant circule majoritairement dans le transistor M8, le signal sur le noeud 702, respectivement 704, est à un niveau bas, respectivement haut, et, à l'inverse, lorsque le courant circule majoritairement dans le transistor M9, le signal sur le noeud 702, respectivement 704, est à un niveau haut, respectivement bas.

Selon un mode de réalisation, la grille du transistor M8 est couplée à l'entrée 522 par un circuit similaire au circuit 610 décrit en relation avec la figure 6, la grille du transistor M9 est couplée à l'entrée 526 par un circuit similaire au circuit 610 décrit en relation avec la figure 6, et, de préférence, le noeud 704 est couplé à la sortie 524 par encore un autre circuit similaire au circuit 610 décrit en relation avec la figure 6.

Le circuit 520 comprend, par exemple, une capacité 706 couplant l'entrée 522 à la grille du transistor M8. Par exemple, une électrode de la capacité 706 est couplée, de préférence connectée, à l'entrée 522, l'autre électrode de la capacité 706 étant couplée, de préférence connectée, à la grille du transistor M8. En outre, le circuit 520 comprend, par exemple, une résistance R7 couplant la grille du transistor M8 à un noeud 707 du circuit 520, le noeud 707 étant configuré pour recevoir une tension continue VDC2. Par exemple, une borne de la résistance R7 est couplée, de préférence connectée, à la grille du transistor M8, l'autre borne de la résistance R7 étant couplée, de préférence connectée, au noeud 707. La résistance R7 et la capacité 706 forment un circuit similaire au circuit 610 décrit en relation avec la figure 6, qui couple l'entrée 522 à la grille du transistor M8.

Le circuit 520 comprend, par exemple, une capacité 708 couplant l'entrée 526 à la grille du transistor M9. Par exemple, une électrode de la capacité 708 est couplée, de préférence connectée, à l'entrée 526, l'autre électrode de la capacité 708 étant couplée, de préférence connectée, à la grille du transistor M9. En outre, le circuit 520 comprend, par exemple, une résistance R8 couplant la grille du transistor M9 au noeud 707 du circuit 520. Par exemple, une borne de la résistance R8 est couplée, de préférence connectée, à la grille du transistor M9, l'autre borne de la résistance R8 étant couplée, de préférence connectée, au noeud 707. La résistance R8 et la capacité 708 forment un autre circuit similaire au circuit 610 décrit en relation avec la figure 6, qui couple l'entrée 526 à la grille du transistor M9.

Ainsi, la tension VDC2 fixe la composante continue sur la grille des transistors M8 et M9. A titre d'exemple, la tension VDC2 est déterminée de sorte que le transistor M8, respectivement M9, fonctionne en saturation (passant) lorsque le signal cmd3, respectivement cmd4, est à son premier niveau, par exemple haut, et de sorte que le transistor M8, respectivement M9, soit bloqué lorsque le signal cmd3, respectivement cmd4, est à son deuxième niveau, par exemple bas.

De préférence, les résistances R7 et R8 sont identiques et les capacités 704 et 708 sont identiques, c'est-à-dire que les résistances R7 et R8 ont une même valeur de résistance et que les capacités 704 et 708 ont une même valeur de capacité.

Le circuit 520 comprend, par exemple, une capacité 710 couplant le noeud 704 à la sortie 524 du circuit 520. Par exemple, une électrode de la capacité 710 est couplée, de préférence connectée, au noeud 704, l'autre électrode de la capacité 710 étant couplée, de préférence connectée, à la sortie 524. En outre, le circuit 520 comprend, par exemple, une résistance R9 couplant la sortie 524 du circuit 520 à un noeud 711 du circuit 520, le noeud 711 étant configuré pour recevoir une tension continue VDC3. Par exemple, une borne de la résistance R9 est couplée, de préférence connectée, à la sortie 524, l'autre borne de la résistance R9 étant couplée, de préférence connectée, au noeud 704. La résistance R9 et la capacité 710 forment encore un autre circuit similaire au circuit 610 décrit en relation avec la figure 6, couplant le noeud 704 à la sortie 524.

Ainsi, la tension VDC3 fixe la composante continue sur la sortie 524 du circuit 520.

Dans l'exemple de la figure 7, lorsque les signaux sur les entrées 522 et 526 sont respectivement à l'état haut et à l'état bas, le signal sur la sortie 524 est à l'état haut, et, à l'inverse, lorsque les signaux sur les entrées 522 et 526 sont respectivement à l'état bas et à l'état haut, le signal sur la sortie 524 est à l'état bas. Dans d'autres exemples, la capacité 710 est connectée au noeud 702 plutôt qu'au noeud 704, de sorte que lorsque les signaux sur les entrées 522 et 526 sont respectivement à l'état haut et à l'état bas, le signal sur la sortie 524 est à l'état bas, et, à l'inverse, lorsque les signaux sur les entrées 522 et 526 sont respectivement à l'état bas et à l'état haut, le signal sur la sortie 524 est à l'état haut. Ainsi, selon l'exemple de circuit 520 considéré, le signal sur la sortie 524 est en phase ou en opposition de phase avec le signal sur l'entrée 522, ce qui détermine, par exemple, si le premier niveau du signal O1, respectivement O2, est un niveau haut ou bas.

La figure 8 représente sous la forme de blocs, une variante de mode de réalisation du dispositif 2 de la figure 2.

Les dispositifs 2 des figures 2 et 8 comprennent de nombreux éléments en commun, et seules les différences entre ces dispositifs sont ici mises en exergue. Plus particulièrement, par rapport au dispositif 2 de la figure 2, le dispositif 2 de la figure 8 comprend en outre un circuit d'écriture et de mémorisation 800.

Le circuit 800 est mis en oeuvre en CML, ou, dit autrement, le circuit 800 est un circuit d'écriture et de mémorisation à commutation en courant.

Le circuit 800 comprend une entrée D1 configurée pour recevoir le signal O1, une entrée D2 configurée pour recevoir le signal O2, une sortie Q1 configurée pour fournir un signal de sortie mem1 et une sortie Q2 configurée pour fournir un signal de sortie mem2.

Le circuit 800 est configuré de sorte que les niveaux des signaux mem1 et mem2, en l'espèce des signaux carrés, soient déterminés par les niveaux respectifs des signaux O1 et O2 quand les signaux sig11 et sig31 sont simultanément à leurs premiers niveaux, et soient maintenus (mémorisés) sinon, c'est à dire quand l'un et/ou l'autre des signaux sig11 et sig31 est à son deuxième niveau. Dit autrement, quand les deux signaux sig11 et sig31 sont simultanément à leurs premiers niveaux, le niveau du signal mem1 est déterminé par le niveau du signal O1 et le niveau du signal mem2 est déterminé par le niveau du signal O2, sinon les niveaux des signaux mem1 et mem2 sont maintenus à leurs niveaux courants. Dit encore autrement, quand les signaux sig11 et sig31 sont simultanément à leurs premiers niveaux, le circuit 800 est dans une phase d'écriture des signaux mem1 et mem2 à partir des signaux respectivement O1 et O2, et dans une phase de mémorisation sinon.

La durée pendant laquelle le niveau des signaux O1 et O2 indique lequel des signaux sig1 et sig3 est le signal I est sensiblement égale à un quart de la période des signaux sig1 et sig3. Or, à des fréquences supérieures au GHz et pouvant aller jusqu'à 10 GHz, il peut être difficile d'observer les niveaux des signaux O1 et O2 pendant ce quart de période.

La prévision du circuit 800 dans le dispositif 2 permet que les niveaux des signaux mem1 et mem2 soient constants et soient différents selon que le signal sig1 soit le signal I ou que le signal sig3 soit le signal I.

Selon un mode de réalisation, le circuit de mémorisation 800 comprend une première bascule 802 et une deuxième bascule 804. Les deux bascules 802 et 804 sont implémentées en CML, ou, dit autrement, chaque bascule 802, 804 est une bascule à commutation en courant.

La bascule 802 est configurée pour recevoir le signal O1 et fournir le signal mem1, la bascule 804 étant configurée pour recevoir le signal O2 et fournir le signal mem2. De préférence, les bascules 802 et 804 sont identiques. Par exemple, la bascule 802, respectivement 804, a une entrée i5 couplée, de préférence connectée, à l'entrée D1, respectivement D2, du circuit 800 et une sortie o couplée, de préférence connectée, à la sortie Q1, respectivement Q2, du circuit 800.

Chaque bascule 802, 804 est en outre configurée pour recevoir au moins un signal cmd13 lui indiquant quand les signaux sig11 et sig31 sont simultanément à leurs premiers niveaux et quand ce n'est pas le cas.

Selon un mode de réalisation, chacune des bascules 802 et 804 reçoit un signal de commande cmd13, un signal de commande cmd1n3, un signal de commande cmd1n3n et un signal de commande cmd13n. Le signal cmd13 est configuré pour indiquer lorsque les signaux sig11 et sig31 sont simultanément à leurs premiers niveaux. Le signal cmd1n3 est configuré pour indiquer lorsque le signal sig11 et le signal sig31 sont simultanément et respectivement au deuxième niveau et au premier niveau. Le signal cmd13n est configuré pour indiquer lorsque le signal sig11 et le signal sig31 sont simultanément et respectivement au premier niveau et au deuxième niveau. Le signal cmd1n3n est configuré pour indiquer lorsque les signaux sig11 et sig31 sont simultanément à leurs deuxièmes niveaux. A titre d'exemple, chacune des bascules 802 et 804 comprend une entrée i1 configurée pour recevoir le signal cmd13, une entrée i2 configurée pour recevoir le signal cmd1n3, une entrée i3 configurée pour recevoir le signal cmd13n et une entrée i4 configurée pour recevoir le signal cmd1n3n.

Selon un mode de réalisation, le circuit 800 comprend une porte logique 806 à commutation en courant configurée pour fournir les signaux cmd13, cmd1n3, cmd13n et cmd1n3, par exemple à partir d'au moins les signaux sig11 et sig31, de préférence à partir des signaux sig11, sig21, sig31 et sig41.

Selon un mode de réalisation, la porte logique 806 est configurée pour fournir les signaux cmd13, cmd1n3, cmd13n et cmd1n3n à partir des signaux sig11, sig21, sig31 et sig41, et le circuit 200 est configuré pour recevoir les signaux sig1, sig2, sig3 et sig4 et pour fournir les signaux sig11, sig21, sig31 et sig41, le circuit 208 pouvant alors comprendre les entrées Rn et Sn en plus de ses entrées S et R.

Selon un mode de réalisation, la porte logique 806 est configurée pour recevoir les signaux sig11, sig21, sig31 et sig41 et pour générer les signaux cmd13, cmd1n3, cmd13n et cmd1n3n à partir de ces signaux sig11, sig21, sig31 et sig41. Selon une variante de réalisation dans laquelle les circuits 520 du circuit 800 sont mis en oeuvre de la façon décrite en relation avec la figure 7, la porte logique 806 est configurée pour recevoir les signaux des noeuds 702 et 704 de chacun des deux circuits 520, et pour générer les signaux cmd13, cmd1n3, cmd13n et cmd1n3n à partir de ces signaux.

La figure 9 représente un exemple d'un mode de réalisation de la bascule 802 du circuit 800 de la figure 8.

La bascule 802 comprend un circuit à commutation en courant 900 configuré pour recevoir un signal carré et pour fournir un signal carré sigc en phase avec le signal reçu et un signal carré sigcn en opposition de phase avec le signal reçu. Dans l'exemple de la figure 9, le circuit 900 est configuré pour recevoir le signal O1 reçu par une entrée i5 de la bascule 802, et est donc connecté à cette entrée i5.

La bascule 802 comprend un transistor MOS M10 connecté entre le noeud 500 de référence et un noeud 902 de la bascule. Une grille du transistor M10 est configurée pour recevoir le signal cmd13. Par exemple, la grille du transistor M10 est couplée, de préférence connectée, à l'entrée i1 de la bascule 802. A titre d'exemple, le transistor M10 est à canal N et a sa source couplée, de préférence connectée, au noeud 500 et son drain couplé, de préférence connecté, au noeud 902. Le signal cmd13 est à un premier niveau, de préférence haut, si les signaux cmd11 et cmd31 sont simultanément à leurs premiers niveaux, et à un deuxième niveau, de préférence bas, sinon.

La bascule 802 comprend un transistor MOS M11 connecté entre le noeud 902 et un noeud 904 de la bascule 802. Une grille du transistor M11 est configurée pour recevoir le signal sigc fourni par le circuit 900. A titre d'exemple, le transistor M11 est à canal N et a sa source couplée, de préférence connectée, au noeud 902 et son drain couplé, de préférence connecté, au noeud 904. La bascule 802 comprend une résistance R10 couplant le noeud 904 au noeud 514 d'alimentation.

De manière symétrique ou complémentaire, la bascule 802 comprend un transistor MOS M12 connecté entre le noeud 902 et un noeud 906 de la bascule 802. Une grille du transistor M12 est configurée pour recevoir le signal sigcn fourni par le circuit 900. A titre d'exemple, le transistor M12 est à canal N et a sa source couplée, de préférence connectée, au noeud 902 et son drain couplé, de préférence connecté, au noeud 906. La bascule 802 comprend une résistance R11 couplant le noeud 906 au noeud 514 d'alimentation.

De préférence, les résistances R10 et R11 sont identiques.

De préférence, les transistors M11 et M12 ont les mêmes dimensions.

Le transistor M10 permet, par exemple, de polariser une paire différentielle comprenant les transistors M11 et M12 à partir du signal cmd13.

La bascule 802 comprend en outre des transistors MOS M13, M14 et M15, chacun connectés entre le noeud 500 et un noeud 908 de la bascule 802. A titre d'exemple, les transistors M13, M14 et M15 sont à canal N et ont tous leurs sources couplées, de préférence connectées, au noeud 500, et leurs drains couplés, de préférence connectés, au noeud 908. De préférence, les transistors M13, M14 et M15 ont les mêmes dimensions, ces dimensions étant par exemple les mêmes que celles du transistor M10.

Une grille du transistor M13 est configurée pour recevoir le signal cmd1n3. Par exemple, la grille du transistor M13 est couplée, de préférence connectée, à l'entrée i2 de la bascule 802. Le signal cmd1n3 est à un premier niveau, de préférence haut, si les signaux cmd11 et cmd31 sont simultanément et respectivement au deuxième niveau et au premier niveau, et à un deuxième niveau, de préférence bas, sinon.

Une grille du transistor M14 est configurée pour recevoir le signal cmd13n. Par exemple, la grille du transistor M14 est couplée, de préférence connectée, à l'entrée i3 de la bascule 802 configurée pour recevoir le signal cmd13n. Le signal cmd13n est à un premier niveau, de préférence haut, si les signaux cmd11 et cmd31 sont simultanément et respectivement à leur premier niveau et à leur deuxième niveau, et à un deuxième niveau, de préférence bas, sinon.

Une grille du transistor M15 est configurée pour recevoir le signal cmd1n3n. Par exemple, la grille du transistor M15 est couplée, de préférence connectée, à l'entrée i4 de la bascule 802 configurée pour recevoir le signal cmd1n3n. Le signal cmd1n3n est à un premier niveau, de préférence haut, si les signaux cmd11 et cmd31 sont simultanément à leurs deuxièmes niveaux, et à un deuxième niveau, de préférence bas, sinon.

La bascule 802 comprend en outre deux transistors MOS M16 et M17. Le transistor M16 est connecté entre le noeud 908 et le noeud 906, et a sa grille connectée au noeud 904. De manière symétrique, le transistor M17 est connecté entre le noeud 908 et le noeud 904, et a sa grille connectée au noeud 906. Les transistors M16 et M17 ont, par exemple, les mêmes dimensions.

De plus, l'un des noeuds 906 et 904, dans cet exemple le noeud 906, est couplé, par exemple connecté, à la sortie o de la bascule 802, configurée pour fournir le signal de sortie mem1 de la bascule 802.

Selon un mode de réalisation, le circuit 900 comprend un transistor MOS M18 connecté entre le noeud de référence 500 et un noeud 9002 du circuit 900. Le transistor M18 a une grille configurée pour recevoir une tension de polarisation Vpol2. A titre d'exemple, le transistor MOS M18 est à canal N et a sa source couplée, de préférence connectée, au noeud 500 et son drain couplé, de préférence connecté, au noeud 9002. Le circuit 900 comprend en outre un transistor MOS M19 connecté entre le noeud 9002 et un noeud 9004 du circuit 900. A titre d'exemple, le transistor MOS M19 est à canal N et a sa source couplée, de préférence connectée, au noeud 9002, et son drain couplé, de préférence connecté, au noeud 9004. La grille du transistor M19 de la bascule 802 est configurée pour recevoir le signal O1, et est donc couplée, de préférence connectée, à l'entrée i5 de la bascule 802. Une résistance R13 du circuit 900 couple le noeud 9004 au noeud d'alimentation 514. De manière complémentaire ou symétrique, le circuit 900 comprend un transistor M20 connecté entre le noeud 9002 et un noeud 9006 du circuit 900. A titre d'exemple, le transistor MOS M20 est à canal N et a sa source couplée, de préférence connectée, au noeud 9002, et son drain couplé, de préférence connecté, au noeud 9006. La grille du transistor M20 est couplée, de préférence connectée, au noeud 9004. Une résistance R12 couple le noeud 9006 au noeud d'alimentation 514. Le signal sigc, respectivement sigcn, est disponible sur le noeud 9006, respectivement 9004, du circuit 900.

Bien que cela ne soit pas illustrée, la bascule 804 est identique à la bascule 802, à la différence que l'entrée i5 de la bascule 804 reçoit le signal O2 et que la sortie o de la bascule 804 fournit le signal mem2.

Dans une variante de réalisation non illustrée, les transistors M13, M14 et M15 de chaque bascule 802, 804 sont remplacés par un unique transistor MOS dont la grille reçoit un signal complémentaire du signal cmd13. Toutefois, cela peut résulter en l'introduction d'un décalage de la composante continue sur les noeuds 906 et 904 entre la phase d'écriture et la phase de mémorisation.

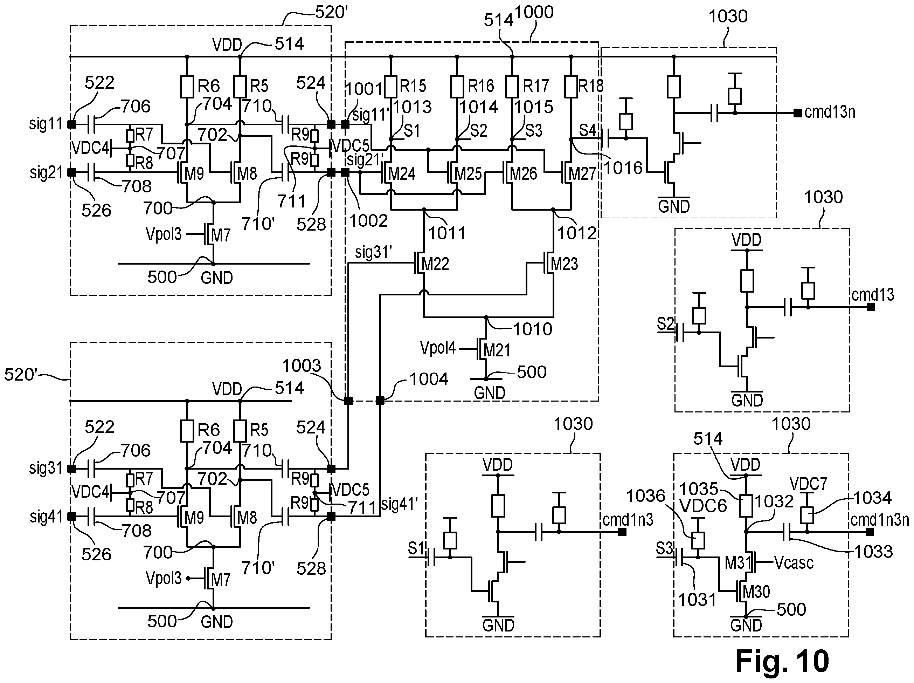

La figure 10 représente un exemple d'un mode de réalisation de la porte 806 du circuit 800 de la figure 8.

La porte logique 806 comprend une porte NON-ET à commutation en courant, référencée 1000 et délimitée par des traits en pointillés en figure 10. La porte 1000 est configurée pour revoir quatre signaux sig11', sig21', sig31' et sig41' déterminés par les signaux respectivement sig11, sig21, sig31 et sig41, et pour fournir des signaux de sortie S1, S2, S3 et S4.

Selon un mode de réalisation, la porte 1000 comprend quatre entrées 1001, 1002, 1003 et 1004. Les entrées 1001 et 1002 sont configurées pour recevoir des signaux en opposition de phase, par exemple les signaux sig11' et sig21' en figure 10, les entrées 1003 et 1004 étant configurés pour recevoir deux autres signaux en opposition de phase, par exemple les signaux sig31' et sig41' en figure 10. En outre, la porte 1000 comprend sept transistors MOS M21, M22, M23, M24, M25, M26 et M27. Le transistor M21 est connecté entre le noeud 500 et un noeud 1010, le transistor M22 est connecté entre le noeud 1010 et un noeud 1011, le transistor M23 est connecté entre le noeud 1010 et un noeud 1012, le transistor M24 est connecté entre le noeud 1011 et un noeud 1013, le transistor M25 est connecté entre le noeud 1011 et un noeud 1014, le transistor M26 est connecté entre le noeud 1012 et un noeud 1015 et le transistor M26 est connecté entre le noeud 1012 et un noeud 1016. Les grilles des transistors M22, M23, M24, M25, M26 et M27 sont couplées, de préférence connectées, aux entrées respectivement 1003, 1004, 1002, 1001, 1002 et 1001 de la porte 1000. En outre, des résistances R15, R16, R17 et R18 couplent les noeuds respectifs 1013, 1014, 1015 et 1016 au noeud 514. Les signaux S1, S2, S3 et S4 sont disponibles sur les noeuds respectifs 1013, 1014, 1015 et 1016. La grille du transistor M21 reçoit une tension de polarisation Vpol4.

Dans l'exemple illustré par la figure 10, la porte 806 reçoit les signaux sig11, sig21, sig31 et sig41.

Selon un mode de réalisation, la porte 806 comprend alors deux circuits 520' similaires au circuit 520 décrit en relation avec la figure 7. Plus particulièrement, chaque circuit 520' diffère du circuit 520 décrit en relation avec la figure 7 en ce que :
le circuit 520' comprend en outre une sortie 528 ;
le circuit 520' comprend en outre une capacité 710', par exemple identique à la capacité 710, couplant le noeud 702 à la sortie 528 ;
le circuit 520' comprend en outre une résistance R9', par exemple identique à la résistance R9, couplant la sortie 528 au noeud 711 ;
la tension de polarisation reçue par la grille du transistor M7 est une tension Vpol3 pouvant être différente de la tension Vpol1 (figure 7) ;
la tension continue reçue par le noeud 707 est une tension VDC4 pouvant être différente de la tension VDC2 (figure 7) ; et
la tension continue reçue par le noeud 711 est une tension VDC5 pouvant être différente de la tension VDC3 (figure 7).

Dans un tel mode de réalisation, les entrées 522 et 526 et les sorties 524 et 528 d'un premier des deux circuits 520' sont configurées pour recevoir les signaux sig11 et sig21 et pour fournir les signaux sig11' et sig21', et les entrées 522 et 526 et les sorties 524 et 528 d'un deuxième des deux circuits 520' sont configurées pour recevoir les signaux sig31 et sig41 et pour fournir les signaux sig31' et sig41'.

Dans une variante de réalisation (non illustrée), la porte 806 comprend quatre circuits identiques au circuit 520 décrit en relation avec la figure 6 à la différence que la tension continue reçue par le noeud 608 de chacun de ces quatre circuits peut être différente de la tension VDC1 (figure 6). Dans cette variante, un premier de ces quatre circuits reçoit le signal sig11 et fournit le signal sig11', un deuxième de ces quatre circuits reçoit signal sig21 et fournit le signal sig21', un troisième de ces quatre circuits reçoit le signal sig31 et fournit le signal sig31' et un quatrième de ces quatre circuits reçoit le signal sig41 et fournit le signal sig41'.

Dans un autre exemple non illustré, la porte 806 ne reçoit pas les signaux sig11, sig21, sig31 et sig41. Selon un mode de réalisation, la porte 806 reçoit alors les quatre signaux disponibles sur les noeuds 704 et 702 des deux circuits 520 du circuit 208 implémentés de la manière décrite en relation avec la figure 7. A titre d'exemple, les quatre signaux sig11', sig21', sig31' et sig41' correspondent alors aux quatre signaux disponibles sur les noeuds 704 et 702 des circuits 520 du circuit 208 lorsque ces circuits 520 sont mis en oeuvre de la façon décrite en relation avec la figure 7. Dans un autre exemple, les signaux sig11', sig21', sig31' et sig41' sont obtenus en sortie de quatre circuits 520 qui sont mis en oeuvre de la façon décrite en relation avec la figure 6 et qui sont connectés respectivement aux noeuds 704 et 702 des deux circuits 520 du circuit 208 lorsque ces deux circuits 520 sont mis en oeuvre de la façon décrite en relation avec la figure 7.

Les transistors de la porte 1000 sont, par exemple, à canal N, d'où il résulte qu'un signal de sortie S1, S2, S3, S4 de la porte 1000 est à un niveau bas uniquement lorsque les deux transistors qui relient le noeud de fourniture de ce signal S1, S2, S3, S4 au noeud 500 reçoivent tous les deux des signaux aux niveaux hauts. Ainsi, dans des exemples où : les premiers niveaux, respectivement les deuxièmes niveaux, des signaux sig11, sig21, sig31 et sig41 sont des niveaux hauts, respectivement bas ; et les signaux sig11', sig21', sig31' et sig41' sont en phase avec les signaux sig11, sig21, sig31 et sig41, alors quand les signaux sig11 et sig31 sont simultanément à leurs premiers niveaux, le signal S2 dans l'exemple de la figure 10 est à son niveau bas et les autres signaux S1, S3 et S4 sont tous au niveau haut. En se référant de nouveau à la figure 9, dans le cas où les transistors M10 et M13 à M15 sont à canal N, il faut que le transistor M10 soit passant quand les deux signaux sig11 et sig31 sont à leurs niveaux hauts (premiers niveaux des signaux sig11 et sig31), et que les transistors M13 à M15 soient alors bloqués. On comprend donc qu'il faut inverser le signal S2 pour obtenir le signal cmd13. De la même façon, il faut inverser les signaux S1, S3 et S4 pour obtenir les signaux cmd1n3, cmd13n et cmd1n3n.

Dans d'autres exemples où les niveaux haut et bas d'au moins certains signaux sont inversés par rapport à ce qui a été indiqué ci-dessus à titre d'exemple, les inversions d'au moins certains signaux S1, S2, S3 et S4 peuvent être omises.

Dans des exemples où les signaux S1, S2, S3 et S4 sont inversés pour obtenir les signaux cmd13, cmd1n3, cmd13n et cmd1n3n, la porte 806 comprend quatre inverseurs 1030. Chaque inverseur 1030 est configuré pour fournir un signal de sortie ayant un niveau inversé par rapport au signal d'entrée de l'inverseur, tout en conservant un écart (ou dynamique) entre les niveaux haut et bas du signal de sortie qui soit le même que celui entre les niveaux haut et bas du signal d'entrée. Les inverseurs 1030 sont configurés pour recevoir les signaux S1, S2, S3 et S4 et pour fournir les signaux cmd13, cmd1n3, cmd13n et cmd1n3n.

Par exemple, comme cela est représenté dans l'exemple de la figure 10, l'inverseur 1030 connecté au noeud 1013 fournit le signal cmd1n3, l'inverseur 1030 connecté au noeud 1014 fournit le signal cmd13, l'inverseur 1030 connecté au noeud 1015 fournit le signal cmd1n3n et l'inverseur 1030 connecté au noeud 10167 fournit le signal cmd13n.

A titre d'exemple, comme cela est illustré pour seulement l'un des inverseurs 1030 (en bas à droite en figure 10), chaque inverseur 1030 comprend une capacité 1031 configurée pour recevoir le signal d'entrée sur une première électrode et ayant sa deuxième électrode couplée, de préférence connectée, à la grille d'un transistor MOS M30. Le transistor M30 est connecté entre le noeud 500 et un noeud 1032 de l'inverseur. Par exemple, le transistor M30 a une borne de conduction connectée au noeud 500 et une autre borne de conduction couplée au noeud 1032 par un transistor MOS M31. Le transistor M31 est monté en cascode avec le transistor M30, et reçoit donc une tension de polarisation Vcasc sur sa grille. Dans un autre exemple, le transistor M31 peut être omis. Une capacité 1033 de l'inverseur 1030 couple le noeud 1032 à la sortie de l'inverseur. L'inverseur comprend en outre une résistance 1036 couplant la grille du transistor M30 à une tension continue VDC6, une résistance 1035 couplant le noeud 1032 au noeud 514, et une résistance 1034 couplant la sortie de l'inverseur à une tension VDC7.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le dispositif 2 peut comprendre, à la suite du circuit 800, un circuit configuré pour recevoir les signaux mem1 et mem2 et pour fournir des signaux correspondants adaptés à un traitement par un circuit CMOS, c'est-à-dire des signaux dont les niveaux haut et bas sont sensiblement égaux aux tensions respectives VDD et GND.

Dans la présente demande, lorsqu'il est indiqué à titre d'exemple que le premier niveau d'un signal carré est un niveau haut, respectivement bas, la personne du métier est mesure d'adapter les modes de réalisation et variantes décrits à d'autres exemples où le premier niveau de ce signal carré est un niveau bas, respectivement haut.

Par ailleurs, bien que l'on ait décrit des exemples de mode de réalisation dans lesquels les transistors sont à canal N et la tension VDD est positive par rapport à la tension de référence GND, la personne du métier est en mesure d'adapter la description faite au cas où la tension VDD est négative par rapport à la tension GND, par exemple en remplaçant tous les transistors à canal N par des transistors à canal P.

Enfin, la mise en oeuvre pratique des modes de réalisation et variantes décrits est à la portée de la personne du métier à partir des indications fonctionnelles données ci-dessus. En particulier, la personne du métier est en mesure de déterminer la valeur des tensions de polarisation Vpol1, Vpol2, Vpol3, Vpol4 et Vcasc et des tensions continues VDC1, VDC2, VDC3, VDC4, VDC5, VDC6 et VDC7 pour obtenir le fonctionnement décrit en relation avec la figure 2 ou la figure 8.

## Revendications

1. Dispositif comprenant :
un premier circuit (200) destiné à recevoir un premier signal sinusoïdal (sig1) et un deuxième signal sinusoïdal (sig3) en quadrature l'un par rapport à l'autre, le premier circuit (200) étant configuré pour fournir :
- un premier signal carré (sig11) ayant un premier niveau si le premier signal sinusoïdal (sig1) est positif par rapport à sa composante continue (DC1) et un deuxième niveau sinon, et
- un deuxième signal carré (sig31) ayant un premier niveau si le deuxième signal sinusoïdal (sig3) est positif par rapport à sa composante continue (DC3) et un deuxième niveau sinon; et
une porte logique à commutation en courant (208) configurée pour recevoir les premier et deuxième signaux carrés (sig11, sig31), et pour fournir :
- un troisième signal carré (O1) à un premier niveau et un quatrième signal carré (O2) à un deuxième niveau quand les premier et deuxième signaux carrés (sig11, sig31) sont simultanément à leurs premier niveaux et que le premier signal carré est en avance de phase sur le deuxième signal carré ; et
- le troisième signal carré (O1) à un deuxième niveau et le quatrième signal carré (O2) à un premier niveau quand les premier et deuxième signaux carrés (sig11, sig31) sont simultanément à leurs premier niveaux et que le deuxième signal carré est en avance de phase sur le premier signal carré.

2. Dispositif selon la revendication 1, dans lequel la porte logique est configurée pour que :
- le troisième signal carré (O1) commute de son premier niveau à son deuxième niveau uniquement lorsque le deuxième signal carré (sig31) commute de son deuxième niveau à son premier niveau pendant le premier niveau du premier signal carré (sig11), le troisième signal carré (O1) restant ensuite à son deuxième niveau uniquement tant que les premier et deuxième signaux carrés (sig11, sig31) restent à leurs premiers niveaux ; et
- le quatrième signal carré (O2) commute de son premier niveau à son deuxième niveau uniquement lorsque le premier signal carré (sig11) commute de son deuxième niveau à son premier niveau pendant le premier niveau du deuxième signal carré (sig31), le quatrième signal carré (O2) restant ensuite à son deuxième niveau uniquement tant que les premier et deuxième signaux carré (sig11, sig31) restent à leurs premiers niveaux.

3. Dispositif selon la revendication 1 ou 2, dans lequel :
le premier circuit (200) comprend deux circuits de conversion (202) identiques, chaque circuit de conversion (202) comprenant:
- un noeud d'entrée (204) et un noeud de sortie (206),
- un inverseur (2000) ayant une sortie couplée au noeud de sortie (206),
- une résistance (2002) couplant une entrée de l'inverseur (2000) à la sortie de l'inverseur, et
- une capacité (2004) couplant le noeud d'entrée (204) à l'entrée de l'inverseur (2000) ;
le noeud d'entrée (204) et le noeud de sortie (206) d'un des deux circuits de conversion (202) sont configurés pour respectivement recevoir le premier signal sinusoïdal (sig1) et fournir le premier signal carré (sig11) ; et
le noeud d'entrée et le noeud de sortie de l'autre des deux circuits de conversion sont configurés pour respectivement recevoir le deuxième signal sinusoïdal (sig3) et fournir le deuxième signal carré (sig31).

4. Dispositif selon l'une quelconque des revendications 1 à 3, dans lequel chaque circuit de conversion (202) comprend en outre :
un premier interrupteur (ITA) en série avec ladite résistance (2002), entre l'entrée et la sortie de l'inverseur (2000) ; et
un deuxième interrupteur (ITB) couplant l'entrée de l'inverseur (2000) à une tension (VDD) apte à forcer un état donné de la sortie de l'inverseur (2000) quand le deuxième interrupteur (ITB) est fermé.

5. Dispositif selon l'une quelconque des revendications 1 à 4, dans lequel ladite porte logique (208) comprend :
un noeud de référence (500), un noeud d'alimentation (514) et des premier (502), deuxième (506), troisième (508), quatrième (512), cinquième (504) et sixième (510) noeuds ; un premier transistor (M1) connecté entre le noeud de référence et ledit premier noeud (502) et ayant une grille configurée pour recevoir un premier signal de commande (cmd1) déterminé par le premier signal carré (sig11) ;
un deuxième transistor (M3) connecté entre lesdits premier et deuxième noeuds (502, 506) et ayant une grille connectée audit troisième noeud (508) ;
une première résistance (R1) couplant ledit deuxième noeud (506) audit noeud d'alimentation (514) ;
un troisième transistor (M4) connecté entre lesdits premier et troisième noeuds (502, 508) et ayant une grille connectée audit quatrième noeud (512) ;
une deuxième résistance (R2) couplant ledit troisième noeud (508) audit noeud d'alimentation (514) ;
un quatrième transistor (M2) connecté entre ledit noeud de référence (500) et ledit cinquième noeud (504) et ayant une grille configurée pour recevoir un deuxième signal de commande (cmd2) déterminé par le deuxième signal carré (sig31) ;
un cinquième transistor (M6) connecté entre lesdits cinquième et quatrième noeuds (504, 512) et ayant une grille connectée audit sixième noeud (510) ;
un troisième résistance (R3) couplant ledit sixième noeud (510) audit noeud d'alimentation (514) ;
un sixième transistor (M5) connecté entre lesdits cinquième et sixième noeuds (504, 510) et ayant une grille connectée audit deuxième noeud (506) ; et
une quatrième résistance (R4) couplant ledit quatrième noeud (512) audit noeud d'alimentation (514),
lesdits deuxième et quatrième noeuds (506, 512) étant configurés pour fournir respectivement les troisième et quatrième signaux carrés (O1, O2).

6. Dispositif selon la revendication 5, dans lequel ladite porte logique (208) comprend en outre deux circuits de commande (520) identiques comprenant chacun une entrée (522) et une sortie (524), chaque circuit de commande (520) étant configuré pour fournir, sur sa sortie (524), un signal carré ayant une composante alternative déterminée par la composante alternative d'un signal carré reçu sur son entrée (522) et pour fixer une composante continue du signal fourni sur sa sortie (526), un premier des deux circuits de commande (520) étant configuré pour recevoir le premier signal carré (sig11) sur son entrée (522) et pour fournir le premier signal de commande (cmd1) sur sa sortie (524) et un deuxième des deux circuits de commande (520) étant configuré pour recevoir le deuxième signal (sig31) carré sur son entrée (522) et pour fournir le deuxième signal de commande (cmd2) sur sa sortie (524).

7. Dispositif selon l'une quelconque des revendications 1 à 6, dans lequel le premier circuit (200) est en outre destiné à recevoir un troisième signal (sig2) sinusoïdal en opposition de phase avec le premier signal sinusoïdal (sig1) et un quatrième signal sinusoïdal (sig4) en opposition de phase avec le deuxième signal sinusoïdal (sig2), le premier circuit étant en outre configuré pour fournir :
- un cinquième signal carré (sig21) ayant un premier niveau si le troisième signal sinusoïdal (sig2) est positif par rapport à sa composante continue et un deuxième niveau sinon, et
- un sixième signal carré (sig41) ayant un premier niveau si le quatrième signal sinusoïdal (sig4) est positif par rapport à sa composante continue et un deuxième niveau sinon.

8. Dispositif selon la revendication 7 dans sa dépendance à la revendication 6, dans lequel :
chacun des deux circuits de commande (520) comprend :
- une entrée supplémentaire (526),
- des premier, deuxième et troisième noeuds (700, 702, 704), le troisième noeud (704) étant couplé à la sortie (524) dudit circuit de commande,
- un premier transistor (M7) connecté entre le noeud de référence (500) et le premier noeud (700) dudit circuit de commande et ayant une grille configurée pour recevoir une première tension de polarisation (Vpol1),
- un deuxième transistor (M8) connecté entre les premier (700) et deuxième (702) noeuds dudit circuit de commande et ayant une grille couplée à l'entrée (522) dudit circuit de commande,
- une première résistance (R5) couplant le deuxième noeud (702) dudit circuit de commande au noeud d'alimentation (514),
- un troisième transistor (M9) connecté entre les premier et troisième noeuds (700, 704) dudit circuit de commande et ayant une grille couplée à l'entrée supplémentaire (526) dudit circuit de commande, et
- une deuxième résistance (R6) couplant le troisième noeud (704) dudit circuit de commande au noeud d'alimentation (514) ;
l'entrée supplémentaire (526) du premier circuit de commande est configurée pour recevoir le cinquième signal carré (sig21) ; et
l'entrée supplémentaire (526) du deuxième circuit de commande est configuré pour recevoir le sixième signal carré (sig41).

9. Dispositif selon la revendication 8, dans lequel :
chaque circuit de commande (520) comprend en outre :
une première capacité (706) couplant l'entrée (522) dudit circuit de commande (520) à la grille du deuxième transistor (M8) dudit circuit de commande (520) ;
une troisième résistance (R7) couplant la grille du deuxième transistor dudit circuit de commande (520) à un quatrième noeud (707) dudit circuit de commande (520), ledit quatrième noeud étant configuré pour recevoir une première tension continue (VDC2) ;
une deuxième capacité (708) couplant l'entrée supplémentaire (526) dudit circuit de commande (520) à la grille du troisième transistor (M9) dudit circuit de commande (520) ;
une quatrième résistance (R8) couplant la grille du troisième transistor (M9) dudit circuit de commande (520) audit quatrième noeud (707) ;
une troisième capacité (710) couplant le troisième noeud (704) dudit circuit de commande (520) à la sortie (524) dudit circuit de commande (520) ; et
une cinquième résistance (R9) couplant la sortie (524) dudit circuit de commande à un cinquième noeud (711) dudit circuit de commande, ledit cinquième noeud (711) étant configuré pour recevoir une deuxième tension continue (VDC3).

10. Dispositif selon l'une quelconque des revendications 1 à 9, dans lequel :
le dispositif comprend en outre un circuit d'écriture et de mémorisation (800) à commutation en courant comprenant :
- une première entrée (D1) configurée pour recevoir le troisième signal carré (O1),
- une deuxième entrée (D2) configurée pour recevoir le quatrième signal carré (O2),
- une première sortie (Q1) configurée pour fournir un premier signal de sortie (mem1), et
- une deuxième sortie (Q2) configurée pour fournir un deuxième signal de sortie (mem2); et
le circuit d'écriture et de mémorisation (800) est configuré de sorte qu'un niveau des premier et deuxième signaux de sortie (mem1, mem2) est déterminé par le niveau respectivement des troisième et quatrième signaux carrés (O1, O2) quand les premier et deuxième signaux carrés (sig11, sig31) sont simultanément à leurs premiers niveaux, et pour mémoriser le niveau des premier et deuxième signaux de sortie sinon.

11. Dispositif selon la revendication 10, dans lequel :
le circuit d'écriture et de mémorisation (800) comprend une première bascule (802) à commutation en courant et une deuxième bascule (804) à commutation en courant ;
la première bascule (802) est configurée pour recevoir le troisième signal carré (O1) et fournir le premier signal de sortie (mem1) ; et
la deuxième bascule (804) est configurée pour recevoir le quatrième signal carré (O2) et fournir le deuxième signal de sortie (mem2).

12. Dispositif selon la revendication 11, dans lequel :
chacune des première et deuxième bascules (802, 804) comprend :
- un noeud de référence (500), un noeud d'alimentation (514) et des premier (902), deuxième (904), troisième (906) et quatrième (908) noeuds,
- un circuit (900) à commutation en courant configuré pour recevoir un signal (O1, O2) et pour fournir un signal en phase (sigc) avec le signal reçu et un signal en opposition de phase (sigcn) avec le signal reçu,
- un premier transistor (M10) connecté entre ledit noeud de référence (500) et ledit premier noeud (902), une grille dudit premier transistor (M10) étant configurée pour recevoir un signal (cmd13) indiquant quand les premier et deuxième signaux carrés (sig11, sig31) sont simultanément à leurs premiers niveaux,
- un deuxième transistor (M11) connecté entre lesdits premier et deuxième noeuds (902, 904) et ayant une grille configurée pour recevoir le signal en phase (sigc),
- une première résistance (R10) couplant ledit deuxième noeud (904) au noeud d'alimentation (514),
- un troisième transistor (M12) connecté entre lesdits premier et troisième noeuds (902, 906) et ayant une grille configurée pour recevoir le signal en opposition de phase (sigcn),
- une deuxième résistance (R11) couplant ledit troisième noeud (906) au noeud d'alimentation (514),
- des quatrième, cinquième et sixième transistors (M13, M14, M15) connectés chacun entre le noeud de référence (500) et ledit quatrième noeud (908), une grille du quatrième transistor (M15) étant configurée pour recevoir un signal (cmd1n3n) indiquant quand les premier et deuxième signaux carrés sont simultanément à leurs deuxièmes niveaux, une grille du cinquième transistor (M14) étant configurée pour recevoir un signal (cmd13n) indiquant quand les premier et deuxième signaux carrés sont simultanément et respectivement à leur premier niveau et à leur deuxième niveau, et une grille du sixième transistor (M15) étant configurée pour recevoir un signal (cmd1n3) indiquant quand les premier et deuxième signaux carrés sont simultanément et respectivement à leur deuxième niveau et leur premier niveau,
- un septième transistor (M17) connecté entre lesdits quatrième et deuxième noeuds (908, 904) et ayant une grille connectée audit troisième noeud (906), et
- un huitième transistor (M16) connecté entre lesdits quatrième et troisième noeuds (908, 906) et ayant une grille connecté audit deuxième noeud (904) ;
le circuit à commutation en courant (900) de la première bascule (802) est configuré pour recevoir le troisième signal carré (O1) ;
le circuit à commutation en courant (900) de la deuxième bascule (804) est configuré pour recevoir le quatrième signal carré (O2);
l'un des premier et deuxième noeuds (904, 906) de la première bascule (802) est configuré pour fournir le premier signal de sortie (mem1) ; et
l'un des premier et deuxième noeuds (904, 906) de la deuxième bascule (804) est configuré pour fournir le deuxième signal de sortie (mem2).

13. Dispositif selon la revendication 12, dans lequel chaque circuit à commutation en courant comprend :
- un noeud de référence (500), un noeud d'alimentation (514) et des premier (9002), deuxième (9004) et troisième (9006) noeuds ;
- un premier transistor MOS (M18) connecté entre ledit noeud de référence (500) et ledit premier noeud (9002) et ayant une grille configurée pour recevoir une tension de polarisation (Vpol2);
- un deuxième transistor MOS (M19) connecté entre lesdits premier et deuxième noeuds (9002, 9004) et ayant une grille configurée pour recevoir le signal reçu (O1, O2) par ledit circuit à commutation en courant (900) ;
- un troisième transistor MOS (M20) connecté entre lesdits premier et troisième noeuds (9002, 9006) et ayant une grille connectée audit deuxième noeud (9004) ;
- une résistance (R13) couplant ledit deuxième noeud (9004) audit noeud d'alimentation (514) ; et
- une autre résistance (R14) couplant ledit troisième noeud (9006) audit noeud d'alimentation (514),
lesdits deuxième et troisième noeuds (9004, 9006) étant configurés pour fournir respectivement les signaux en opposition de phase et en phase fournis par ledit circuit à commutation en courant (900).

14. Dispositif selon la revendication 12 ou 13, dans lequel le circuit d'écriture et de mémorisation comprend en outre une porte logique (806) à commutation en courant configurée pour fournir le signal (cmd13) indiquant quand les premier et deuxième signaux carrés (sig11, sig31) sont à leurs premiers niveaux, le signal (cmd1n3n) indiquant quand les premier et deuxième signaux carrés (sig11, sig31) sont à leurs deuxièmes niveaux, le signal (cmd13n) indiquant quand les premier et deuxième signaux carrés (sig11, sig31) sont respectivement à leurs premier et deuxième niveaux, et le signal (cmd1n3) indiquant quand les premier et deuxième signaux carrés (sig11, sig31) sont respectivement à leurs deuxième et premier niveaux.

15. Dispositif selon la revendication 12 ou 13 prise dans sa dépendance à la revendication 7, dans lequel le circuit d'écriture et de mémorisation comprend en outre une porte logique (806) à commutation en courant configurée (800) pour recevoir les premier, deuxième, cinquième et sixième signaux carrés (sig11, sig31, sig21, sig41) et pour fournir, à partir desdits signaux reçus, le signal (cmd13) indiquant quand les premier et deuxième signaux carrés (sig11, sig31) sont à leurs premiers niveaux, le signal (cmd1n3n) indiquant quand les premier et deuxième signaux carrés (sig11, sig31) sont à leurs deuxièmes niveaux, le signal (cmd13n) indiquant quand les premier et deuxième signaux carrés (sig11, sig31) sont respectivement à leurs premier et deuxième niveaux, et le signal (cmd1n3) indiquant quand les premier et deuxième signaux carrés (sig11, sig31) sont respectivement à leurs deuxième et premier niveaux.

16. Dispositif selon la revendication 14 prise dans sa dépendance à la revendication 7, dans lequel la porte logique (806) du circuit d'écriture et de mémorisation (900) comprend :
une porte NON-ET à commutation en courant configurée pour revoir quatre signaux (sig11', sig21', sig31', sig41') déterminés par respectivement par les premier, deuxième, quatrième et cinquième signaux carrés (sig11, sig21, sig31, sig41) et pour fournir des premier, deuxième, troisième et quatrième signaux de sortie (S1, S2, S3, S4) ; et
quatre inverseurs (1030) configurés pour recevoir respectivement les quatre signaux de sortie (S1, S2, S3, S4) de la porte logique NON-ET et pour fournir respectivement le signal indiquant quand les premier et deuxième signaux carrés sont à leurs premiers niveaux, le signal indiquant quand les premier et deuxième signaux carrés sont à leurs deuxièmes niveaux, le signal indiquant quand les premier et deuxième signaux carrés sont respectivement à leurs premier et deuxième niveaux, et le signal indiquant quand les premier et deuxième signaux carrés sont respectivement à leurs deuxième et premier niveaux.
